(19) Europäisches Patentamt
European Patent Office
Office européen des brevets

(11) EP 2 362 460 A1

(12) **EUROPEAN PATENT APPLICATION**
published in accordance with Art. 153(4) EPC

(43) Date of publication:
**31.08.2011 Bulletin 2011/35**

(21) Application number: **10778537.0**

(22) Date of filing: **02.02.2010**

(51) Int Cl.:
***H01L 51/50*** *(2006.01)* ***C09K 11/06*** *(2006.01)*
***H05B 33/12*** *(2006.01)*

(86) International application number:
**PCT/JP2010/051446**

(87) International publication number:
**WO 2011/083588 (14.07.2011 Gazette 2011/28)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **08.01.2010 JP 2010002972**

(71) Applicant: **Mitsubishi Chemical Corporation**
**Tokyo 108-0014 (JP)**

(72) Inventors:
- **IMADA, Ichiro**
  **Yokohama-shi, Kanagawa 2278502 (JP)**
- **GOROHMARU, Hideki**
  **Yokohama-shi, Kanagawa 2278502 (JP)**
- **TAKAHASHI, Atsushi**
  **Yokohama-shi, Kanagawa 2278502 (JP)**

(74) Representative: **Merkle, Gebhard**
**TER MEER STEINMEISTER & PARTNER GbR,**
**Patentanwälte**
**Mauerkircherstrasse 45**
**81679 München (DE)**

(54) **ORGANIC EL ELEMENT AND ORGANIC LIGHT-EMITTING DEVICE**

(57) To provide an organic EL element having high efficiency and long life, without accumulating holes at the interface between a light-emitting layer and a layer on the cathode side, and an organic light-emitting device.

An organic EL element having a light-emitting layer between an anode and a cathode, wherein the light-emitting layer contains a light-emitting material and a charge-transporting material, the element has a hole relaxation layer adjacent to the cathode side of the light-emitting layer, the hole relaxation layer contains a hole-relaxing material, the hole-relaxing material is an organic compound having a hole-transporting unit and an electron-transporting unit, and at least one type of the charge-transporting material and at least one type of the hole-relaxing material are the same organic compound; and an organic light-emitting device containing such an element.

**Fig. 1**

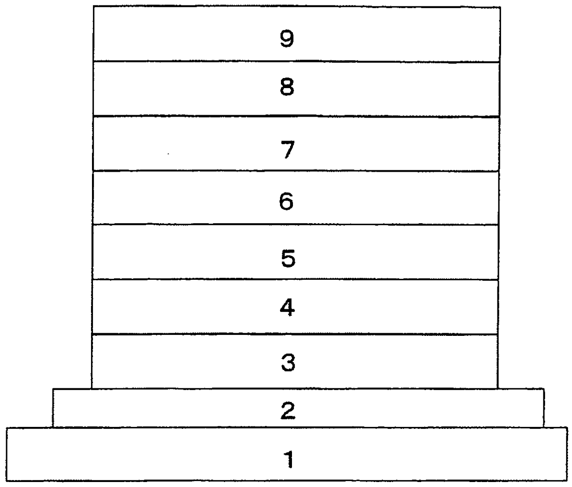


EP 2 362 460 A1

## Description

TECHNICAL FIELD

The present invention relates to an organic EL element having high efficiency and long life, and an organic light-emitting device having such an element.

BACKGROUND ART

For the purpose of increasing luminous efficiency of an organic EL element, an element employing phosphorescence (emission by triplet excitons) instead of fluorescence (emission by singlet excitons) is being studied. By employing phosphorescence, the efficiency is considered to be improved about three times as compared with an element employing fluorescence, and it has been reported to use a europium complex, a platinum complex or the like as phosphorescence molecules. However, conventional organic EL elements employing phosphorescence molecules were practically insufficient with respect to the driving stability although providing emissions with high efficiency, and it has been difficult to realize a display device having high efficiency and long life.

In an organic EL element, emission of light is obtained basically by a combination of a hole transport layer and an electron transport layer. That is, the principle is such that holes injected from an anode are transferred in a hole transport layer and re-combined with electrons injected from a cathode and transferred in an electron transport layer, in the vicinity of the interface of both layers, thereby to excite the hole transport layer and/or the electron transport layer to emit light. Further, an element is common wherein a light-emitting layer is provided between the hole transport layer and the electron transport layer to improve the luminous efficiency.

In the case of a phosphorescence organic EL element, it is common to provide a hole-blocking layer on the cathode side of the light-emitting layer to improve the efficiency and the life. That is, by trapping excitons within the light-emitting layer, the efficiency can be increased (Patent Document 1), and it is possible to prevent deterioration of a layer on the cathode side of the light-emitting layer by holes, whereby the life is considered to be improved.

Whereas, in the case of a fluorescence-emitting organic EL element, deterioration of the luminance characteristics or life may better be prevented by not forming a hole-blocking layer (Patent Document 2). Further, also from the viewpoint of the voltage, it may sometimes be advantageous not to form a hole-blocking layer. Accordingly, in the case of preparing an organic EL display device having red, green and blue organic EL elements, for the purpose of effectively attaining long life, high efficiency and low voltage, it is considered best that in the case where the emission is phosphorescence, a hole-blocking layer is employed, and in the case where the emission is fluorescence, no hole-blocking layer is employed (Patent Document 3).

However, by such a distinguishing method, at the time of preparing an organic EL display device wherein phosphorescence and fluorescence are present as mixed, it becomes necessary to carry out patterning separately in the vacuum vapor deposition method employing a shadow mask. In vapor deposition by means of a shadow mask, along with the trend for a large screen of a substrate, the corresponding enlargement of a metal mask brings about problems such as deficiency in the pattern precision, deficiency in the pattern-positioning precision, etc. (Patent Document 4). Further, at the time of such patterning, problems such as a decrease in the yield due to particles to be generated, an increase of the cost due to such an yield decrease, etc., are conceivable. Thus, the vacuum deposition employing a shadow mask has a problem that it is disadvantageous for mass production or large size modification.

For the purpose of attaining high efficiency and long life in consideration of such problems, it is considered advantageous that a hole-blocking layer made of the same material is vapor deposited and laminated at a position adjacent to the cathode side of each light-emitting layer.

Meanwhile, for common hole-blocking layers heretofore known, a hole-blocking material such as BCP (2,9-dimethyl-4,7-diphenyl-1,10-phenanthroline) or BAlq (aluminum(III)bis(2-methyl-8-quinolinolate)-4-phenylphenolate) is employed. BCP makes it possible to obtain very good efficiency when applied to a phosphorescence organic EL element (Non-Patent Document 1), but is accompanied by such a drawback that the life of an organic EL element containing BCP is substantially limited. T. Tsutsui et al (Non-Patent Document 2) have pointed out that the low stability of BCP is attributable to its poor life, and this means that such a device cannot be used in a high quality display. Further, BAlq has made it possible to significantly improve the stability and life of a device, but has a problem that the quantum efficiency of a device containing BAlq is lower by about 40% as compared with BCP (Non-Patent Document 3). Kwong et al (Non-Patent Document 4) have accomplished a life of 10,000 hours at 100 cd/m$^2$ by using tris(phenylpyridin) iridium (III). However, this device shows only an efficiency as small as 19 cd/A, and thus, although BAlq is capable of obtaining a good life, the obtainable efficiency is low, and it is not a satisfactory hole blocking material.

Further, the hole-blocking layer is defined "to be an electron transport layer in a broad sense, and ··· it blocks holes while transporting electrons ···" (Patent Document 5). However, by using an electron-transporting material as a hole-blocking layer, holes tend to accumulate at the interface between the light-emitting layer and the hole-blocking

layer. Such accumulation of holes at the interface of the layers is considered to be one of the causes for deterioration of the element.

In this regard, for example, Patent Document 6 proposes a method to reduce an increase of the voltage due to accumulation of holes, by employing a material having a hole-transporting ability as a material for an electron transport layer adjacent to the light-emitting layer.

However, there has been a problem that no adequate hole-relaxing effect can thereby be obtainable. Further, the application range of this invention is limited to only a phosphorescent type light-emitting element, and the method has been hardly regarded as a technique to be practically useful.

Accordingly, a new layer is required which prevents diffusion of excitons instead of a hole-blocking layer and which is applicable for a fluorescence-emitting material and a phosphorescence-emitting material and is capable of being vapor-deposited to provide high efficiency and long life.

PRIOR ART DOCUMENTS

PATENT DOCUMENTS

Patent Document 1: JP-A-2001-284056
Patent Document 2: JP-A-2006-156848
Patent Document 3: JP-A-2005-158668
Patent Document 4: JP-A-2003-077660
Patent Document 5: JP-A-2005-044790
Patent Document 6: WO2005/076669

NON-PATENT DOCUMENTS

Non-Patent Document 1: Appl. Phys. Lett. 1999, 74, 442
Non-Patent Document 2: Japanese J. Appl. Phys. 1999, 38, L1502
Non-Patent Document 3: Proc. SPIE 2001, 4105, 175
Non-Patent Document 4: Appl. Phys. Lett. 2002, 81, 162

DISCLOSURE OF THE INVENTION

OBJECTS TO BE ACCOMPLISHED BY THE INVENTION

The present invention has an object to provide an organic EL element having high efficiency and long life without accumulating holes at the interface between a light-emitting layer and a layer adjacent to the cathode side of the light-emitting layer, and an organic light-emitting device having such an element.

The present invention further has an object to provide an organic EL element having high efficiency and long life, which is an organic EL element having a light-emitting layer between an anode and a cathode, wherein the light-emitting layer contains at least two light-emitting materials, and the element has a layer adjacent to the cathode side of the light-emitting layer, and it does not accumulate holes at the interface with the light-emitting layer, and an organic light-emitting device having such an element.

Further, the present invention has an object to provide an organic EL element having high efficiency and long life, which is an organic EL element having a light-emitting layer between an anode and a cathode, wherein the light-emitting layer comprises at least two layers, and the element has a layer adjacent to the cathode side of the light-emitting layer provided nearest to the cathode, and it does not accumulate holes at the interface with the light-emitting layer, and an organic light-emitting device having such an element.

Finally, the present invention has an object to provide an organic EL element having high efficiency and long life, which is an organic EL element having a light-emitting layer between an anode and a cathode, wherein the light-emitting layer contains a charge-transporting material, and the charge transporting material has a detectable amount of holes of from $2.5\times10^{-10}$ to $1\times10^{-8}$ at a field intensity of 160 kV/cm, and the element has a layer adjacent to the cathode side of the light-emitting layer, and it does not accumulate holes at the interface with the light-emitting layer, and an organic light-emitting device having such an element.

MEANS TO ACCOMPLISH THE OBJECTS

As a result of an extensive study, the present inventors have found that the reason as to why the hole relaxation effect in Patent Document 6 is small, is such that the material to be used is a material different from a charge-transporting material used in the light-emitting layer, like in conventional organic EL elements, so that the light-emitting layer and the electron transport layer present bonds (hetero bonds) of different organic materials, which substantially hinders injection of electrons and relaxation of holes.

On the basis of the above discovery, a further study has been made, and as a result, it has been found that by incorporating a light-emitting material and a charge-transporting material to the light-emitting layer, providing a hole relaxation layer containing an organic compound having hole-transporting units and electron-transporting units as a layer adjacent to the cathode side of the light-emitting layer and using the same organic compound as the charge-transporting material and the hole-relaxing material, an organic EL element thereby obtainable, can accomplish high efficiency and long life, and the present invention has been accomplished.

That is, the present invention provides an organic EL element having a light-emitting layer between an anode and a cathode, wherein:

the light-emitting layer contains a light-emitting material and a charge-transporting material,
the element has a hole relaxation layer adjacent to the cathode side of the light-emitting layer,
the hole relaxation layer contains a hole-relaxing material,
the hole-relaxing material is an organic compound having a hole-transporting unit and an electron-transporting unit, and
at least one type of the charge-transporting material and at least one type of the hole-relaxing material are the same organic compound (which may be hereinafter referred to as "organic EL element A").

Further, the present invention provides an organic light-emitting device having red, green and blue organic EL elements, wherein at least one of the red, green and blue organic EL elements is the organic EL element A.

Further, the present invention provides the organic EL element A, wherein the charge-transporting layer has a detectable amount of holes of from $2.5\times10^{-10}$ to $1\times10^{-8}$ at a field intensity of 160kV/cm (which may be hereinafter referred to as "organic EL element B"), and an organic light-emitting device having such an organic EL element B.

Further, the present invention provides the organic EL element A, wherein the light-emitting layer contains at least two light-emitting materials (which may be hereinafter referred to as "organic EL element C"), as well as an organic EL display device and organic EL illumination, having such an organic EL element C.

Further, the present invention provides the organic EL element A, wherein the light-emitting layer comprises at least two layers containing different light-emitting materials from one another (which may be hereinafter referred to as "organic EL element D"), as well as an organic EL display device and organic EL illumination, having such an organic EL element D.

Here, "organic EL element of the present invention" represents all of "organic EL element A", "organic EL element B", "organic EL element C" and "organic EL element D".

Further, "organic light-emitting device" in the present invention represents both "organic EL display device" and "organic EL illumination".

ADVANTAGEOUS EFFECTS OF THE INVENTION

The organic light-emitting device of the present invention has a constantly long life and is capable of suppressing an increase of the voltage with any one of red-, green- and blue-elements.

Further, the organic EL element of the present invention is less susceptible to an increase of the voltage and has a long driving life.

In the case of the organic EL elements C and D of the present invention, they can be made to have a particularly long driving life in the case of emitting white-light.

BRIEF DESCRIPTION OF THE DRAWINGS

Fig. 1 is a cross-sectional view of the organic EL display device of the present invention.
Fig. 2 is a cross-sectional view of the organic EL element D of the present invention.
Fig. 3 is a cross-sectional view of an element for measuring a charge mobility in the present invention.

BEST MODE FOR CARRYING OUT THE INVENTION

The following description of the constituting elements relates to examples (typical examples) of the embodiments of the present invention, and it should be understood that the present invention is by no means thereby restricted.

<Organic EL element A>

The organic EL element A of the present invention is an organic EL element having a light-emitting layer between an anode and a cathode, wherein the light-emitting layer contains a light-emitting material and a charge-transporting material, the element has a hole relaxation layer adjacent to the cathode side of the light-emitting layer, the hole relaxation layer contains a hole-relaxing material, the hole-relaxing material is an organic compound having a hole-transporting unit and an electron-transporting unit, and at least one type of the charge-transporting material and at least one type of the hole-relaxing material are the same organic compound.

By using the hole relaxation layer of the present invention, it is possible to constantly obtain a long life and to prevent an increase of the voltage with any one of the red-, green- and blue-elements.

Heretofore, a hole-blocking layer was laminated at a position to laminate a hole relaxation layer (a layer formed adjacent to the cathode side of the light-emitting layer). A common definition of such a hole blocking layer is "in a broad sense, it is an electron-transporting layer, and · · · by blocking holes while transporting electrons · · ·" (Patent Document 5). It is thus considered that by using an electron-transporting material as a hole-blocking layer, holes will accumulate at the interface between the light-emitting layer and the hole-blocking layer. However, accumulation of holes at the interface is considered to be one of deterioration factors.

Whereas, it is considered that by the use of an organic compound having hole-transporting units and electron-transporting units as the hole-relaxing material for the hole relaxation layer, holes which are otherwise accumulated, will be transported to the hole-transporting units. It is considered that deterioration of the material for light-emitting layer due to accumulation of holes can thereby be reduced.

Further, in the present invention, by using the same organic compound for at least one type of the charge-transporting material and at least one type of the hole-relaxing material, it is considered that formation of a charge injection barrier due to formation of a hetero bond between the light-emitting layer and the hole relaxation layer, will be reduced, so that holes become more easily flowable.

Thus, in the organic EL element of the present invention, by providing a hole relaxation layer containing an organic compound having a specific structure and by using the same organic compound as the charge-transporting material in the light-emitting layer and as the hole-relaxing material in the hole relaxation layer, it is possible to reduce deterioration of the material for light-emitting layer due to accumulation of holes, thereby to prolong the life, and at the same time to prevent an increase of the voltage.

<Hole relaxation layer>

Firstly, the hole relaxation layer will be described. The hole relaxation layer is a layer to be formed adjacent to the cathode side of the light-emitting layer and is a layer having a function to reduce accumulation of holes at the interface between the light-emitting layer and the hole relaxation layer. Further, it also has a role to transport electrons efficiently to the direction of the light-emitting layer.

The ionization potential of the hole relaxation layer is usually at least 5.5 eV, preferably at least 5.6 eV, more preferably at least 5.7 eV, and usually at most 6.7 eV, preferably at most 6.4 eV, more preferably at most 6.0 eV. If the value of this ionization potential is too large or too small, holes are likely to be accumulated at the interface between the light-emitting layer and the hole relaxation layer.

The ionization potential (Ip) can be measured by an ionization potential-measuring apparatus PCR-101 (manufactured by Optel).

The thickness of the hole relaxation layer is optional so long as the effects of the present invention are not substantially impaired, but it is preferably at least 0.3 nm, more preferably at least 0.5 nm, and preferably at most 100 nm, more preferably at most 50 nm. If the thickness is too thin, defects are likely to be formed in the thin film, and if it is too thick, the driving voltage is likely to be high.

The hole relaxation layer is preferably formed by a vapor deposition method. Here, the vapor deposition method is preferably a vacuum vapor deposition method, a laser transfer method, a resistance heating method, an electron beam method, PVD (physical vapor deposition) or CVD (chemical vapor deposition), and a vacuum vapor deposition method is more preferred among them.

On the cathode side of the hole relaxation layer, an electron transport layer is usually formed adjacent thereto, and the difference in the ionization potential between the hole relaxation layer and the electron transport layer is optional so long as the effects of the present invention are not substantially impaired, but it is usually less than 0.5 eV, preferably

less than 0.3 eV, more preferably less than 0.2 eV. If the difference in the ionization potential is large, holes are likely to accumulate in the hole relaxation layer to cause deterioration.

In the present invention, the hole relaxation layer contains a hole-relaxing material. The content of the hole-relaxing material in the hole relaxation layer is preferably from 0.1 to 100 wt%, more preferably from 10 to 100 wt%.

In the present invention, for the hole relaxation layer, as the hole-relaxing material, an organic compound having a hole-transporting unit and an electron-transporting unit, is used. Here, the hole-transporting unit (hole transport unit) is a structure (unit) having a hole-transporting property and excellent durability against holes.

Whereas, the electron-transporting unit (electron transport unit) is a structure (unit) having an electron-transporting property and excellent durability against electrons.

The hole mobility $\mu_H$ of the hole-relaxing material in the present invention is usually at least $1\times10^{-6}$ $cm^{-2}/V\cdot s$, preferably at least $1\times10^{-4}$ $cm^{-2}/V\cdot s$, more preferably at least $1\times10^{-3}$ $cm^{-2}/V\cdot s$, by the following method for measuring the charge mobility.

As the hole mobility is high, it is possible to lower the driving voltage as an element. Therefore, there is no upper limit value for the electron mobility, but it is usually at most $1\times10^{-1}$ $cm^{-2}/V\cdot s$.

Within the above range, the retention time of the charge in the layer is short, and the layer is less likely to be deteriorated by holes or electrons, such being desirable.

Further, the ratio ($\mu_E/\mu_H$) of the electron mobility to the hole mobility of the hole-relaxing material is usually within a range of from 100 to 0.1, preferably from 50 to 0.5, more preferably from 10 to 0.5.

If this ratio ($\mu_E/\mu_H$) is within the above range, holes or electrons are hardly likely to flow from the light-emitting layer to another layer, whereby deterioration of the element by holes or electrons is less likely to occur, and the driving life of the obtainable element will be long, such being desirable.

<Method for measuring charge mobility>

In the present invention, the charge mobility of each compound is measured by the method disclosed in the section of [Measurement of charge mobility] by preparing the following element for measuring the charge mobility and using such element for measuring the charge mobility.

[Preparation of element for measuring charge mobility]

An element for measuring the charge mobility (which may be hereinafter referred to simply as "element for measurement") as shown in Fig. 3 is prepared, and the measurement is carried out by using it.

The element for measurement may be prepared, for example, by the following method.

Firstly, an indium·tin oxide (ITO) transparent conductive film deposited in a thickness of e.g. 150 nm on a glass substrate 1 (a sputter-deposited product, sheet resistance: 15 Ω) is subjected to patterning in stripes with a width of 2 mm by means of a usual photolithography technique to form an anode 2. The substrate having the anode formed thereon is cleaned in the order of ultrasonic cleaning by acetone, water washing by pure water and ultrasonic cleaning by isopropyl alcohol, then dried by nitrogen blowing and finally subjected to treatment such as ultraviolet ray ozone cleaning.

On the substrate after the treatment, a sample layer 10 is formed by using a material to be measured (hereinafter referred to as "material for measurement") by a wet film-forming method or a vacuum vapor deposition method so that the film thickness would be e.g. from 1.5 to 2 $\mu$m.

When the material for measurement is one which is soluble in an organic solvent in an amount of e.g. about 2 wt%, it is formed into a film by a wet film-forming method, particularly by a spin coating method.

The organic solvent is not particularly limited so long as it is capable of dissolving the material for measurement. For example, chloroform, tetrahydrofuran, toluene, xylene or the like may be used in that such a solvent is readily available and inexpensive.

In the case where film forming is carried out by a spin coating method, for example, a composition for measurement is prepared as shown below and formed into a film under the following spin coating conditions, followed by heating to form a film made of the material for measurement.

<Composition for measurement>

| | |
|---|---|
| Solvent | chloroform |
| Concentration in composition | 8.6 wt% |

<Spin coating conditions>

| | |
|---|---|
| Rotational speed of spinner | 300 rpm |
| Rotational time of spinner | 30 seconds |
| Spin coating atmosphere | In atmospheric air |
| Baking conditions | In vacuum at 130˚C for 1 hour |

Further, in the case where film formation by the above spin coating method is difficult, the sample layer may be formed by a vacuum vapor deposition method.

In a vacuum vapor deposition method, an apparatus is roughly evacuated by a scroll pump and then evacuated by means of a turbo molecular pump until the vacuum degree in the apparatus becomes to be e.g. at most $8.0\times10^{-4}$ Pa, and by controlling the vacuum degree during the vapor deposition to be from 0.4 to $0.8\times10^{-4}$ Pa and the vapor deposition rate to be within a range of from 1 to 2 Å/sec, a sample layer is formed on a substrate.

Then, as described above, the substrate having the sample formed thereon is transported into a vapor deposition apparatus, and the apparatus is roughly evacuated by a scroll pump. Then, evacuation is carried out by means of a turbo molecular pump until the vacuum degree in the apparatus becomes to be e.g. at most $8.0\times10^{-4}$ Pa, and gold and aluminum are sequentially laminated by a vacuum vapor deposition method to form a cathode.

While controlling the vacuum degree during the vapor deposition of gold to be e.g. from 0.8 to $3\times10^{-3}$ Pa and the vapor deposition rate to be within a range of from 0.2 to 0.5 Å/sec, a film with a thickness of e.g. 10 nm is laminated on the sample layer. Then, while controlling the vacuum degree during the vapor deposition of aluminum to be e.g. from 0.5 to $2.5\times10^{-3}$ Pa and the vapor deposition rate to be within a range of from 0.2 to 5.0 Å/sec, a film with a thickness of e.g. 80 nm is laminated on the sample layer to obtain a cathode.

Then, in order to prevent deterioration of the element for measurement by e.g. moisture in the atmosphere during the storage, sealing treatment is carried out by the following method. In a nitrogen globe box connected to a vacuum vapor deposition apparatus, a photocurable resin 30Y-437 (manufactured by Three Bond Co., Ltd.) is applied with a width of about 1 mm along the peripheral portion of a glass plate with a size of e.g. 23 mm × 23 mm, and at the center portion, a desiccating agent sheet (manufactured by DYNIC CORPORATION) is set. The element for measurement is bonded thereon so that the surface of the element on which the cathode is vapor-deposited, faces the desiccating agent sheet. Then, only the region coated with the photocurable resin is irradiated with ultraviolet light to cure the resin. As described above, an element for measurement having an element area with a size of 2 mm × 2 mm, is prepared.

[Measurement of charge mobility]

As a method for measuring the charge mobility, a time-of-flight method (ToF method) is employed for the measurement. A filed intensity E (V/cm) is applied so that the ITO layer side of the element for measurement would have a high potential. Then, the ITO layer of the element for measurement is irradiated for a short time with light having a wavelength of 355 nm as third harmonic by means of a Nd:YAG nanosecond pulse laser. A transient photocurrent thereby generated is detected, and its inflection point is taken as the time-of-flight $T_{tr}$ (s). From time-of-flight $T_{tr}$ and the field intensity E (=V/d, V: potential difference between the anode and the cathode of the element for measurement, d: thickness of the sample layer of the element for measurement), the charge mobility $\mu_h$ is calculated by using the following formula:

$$\mu_h = \frac{d^2}{t_{tr} \cdot V}$$

The measurement is carried out at a plurality of field intensities, and the charge mobility at a filed intensity of 160 kV/cm is calculated by using the obtained charge mobility $\mu_h$, the field intensity E and the Poole-Frenkel formula:

$$\mu_h = \mu_0 \cdot \exp(\gamma \cdot \sqrt{E}).$$

The hole-relaxing material to be used in the present invention is an organic compound having a structure

wherein at least one hole-transporting unit and at least one electron-transporting unit are combined in an optional ratio.

The hole-transporting unit in the present invention is a structure (unit) having a hole-transporting property, which is excellent in durability against holes. More specifically, it is a unit which is stable against holes and which has an ionization potential whereby holes can easily be taken out from the light-emitting layer.

The ionization potential whereby the holes can easily be taken out from the light-emitting layer, is usually from 5.4 to 6.3 eV, preferably from 5.5 to 6.2 eV, more preferably from 5.6 to 6.1 eV.

Further, "stable against holes" means that the hole-transporting units are less likely to be decomposed even in a radical state. This means that radical cations are delocalized and stabilized even in a radical state.

A unit structure having such a performance may, for example, be a structure containing hetero atoms having a sp3 orbit, or an aromatic condensed ring having a carbon number of 4n type.

More specifically, it may, for example, be a carbazole ring, a phthalocyanine ring, a naphthalocyanine structure, a porphyrin structure, a triarylamine structure, a triarylphosphine structure, a benzofuran ring, a dibenzofuran ring, a pyrene ring, a phenylenediamine structure, a pyrrole ring, a benzidine structure, an aniline structure, a diarylamine structure, an imidazolidinone structure or a pyrazole ring.

Among them, preferred is a carbazol ring, a benzofuran ring, a dibenzofuran ring, a pyrene ring or a triarylamine structure, more preferred is a carbazol ring, a benzofuran ring, a dibenzofuran ring or a pyrene ring, particularly preferred is a carbazol ring or a pyrene ring, and most preferred is a carbazol ring.

The electron-transporting unit in the present invention is a structure (unit) having an electron-transporting property, which is excellent in durability against electrons. More specifically, it is a unit wherein an electron is easy to enter, and the entered electron is easily stabilized. For example, in the case of a pyridine ring or the like, the ring is slightly electron-deficient due to the nitrogen atom and readily accepts an electron, and an electron entered into the ring is delocalized and stabilized on the pyridine ring.

A unit structure having such a performance may, for example, be a single ring or condensed ring containing a hetero atom having a sp2 hybridized orbit. More specifically, it may, for example, be a quinoline ring, a quinazoline ring, a quinoxaline ring, a phenanthroline ring, a pyridine ring, a pyrimidine ring, a pyridazine ring, a pyrazine ring, a triazine ring, a thiadiazole ring, a benzothiadiazole ring, a quinolinol metal complex, a phenanthroline metal complex, a hexaazatriphenylene structure or a tetrasialbenzoquinoline structure.

Among them, preferred is a quinoline ring, a quinazoline ring, a quinoxaline ring, a phenanthroline ring, a pyridine ring, a pyrimidine ring, a pyridazine ring, a pyrazine ring or a triazine ring, and among them, from the viewpoint of excellent electrical stability, a quinoline ring, a quinazoline ring, a pyridine ring, a pyrimidine ring, a triazine ring or a 1,10-phenanthroline ring is particularly preferred.

Further, in the case where the above electron-transporting unit is a 6-membered single ring or condensed ring containing a nitrogen atom, all of o- and p-positions to the nitrogen atom are preferably substituted by aromatic rings.

That is, the o- and p-positions in a 6-membered ring containing a nitrogen atom are active sites, and when such positions are substituted by aromatic ring groups, electrons will be delocalized. Thus, the structure becomes more stable against electrons.

Thus, the hole-relaxing material in the present invention becomes one excellent in durability against electrical oxidation or reduction.

Whereas, in the case where the electron-transporting unit is a condensed ring, among the o- and p-positions to nitrogen atoms, sites not constituting a part of the condensed ring may be substituted by aromatic ring groups.

As the hole-relaxing material, more preferred is an organic compound having a combination of a ring derivative selected from the following Group (a) (hole-transporting units) and a ring derivative selected from the following Group (b) (electron-transporting units).

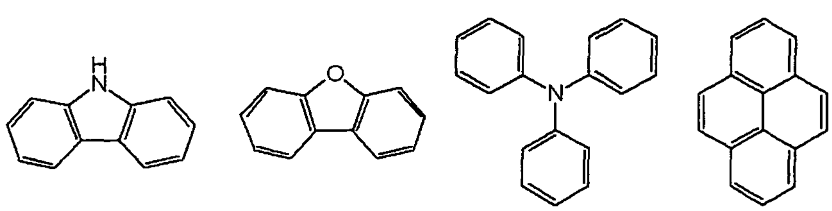

Group (a)

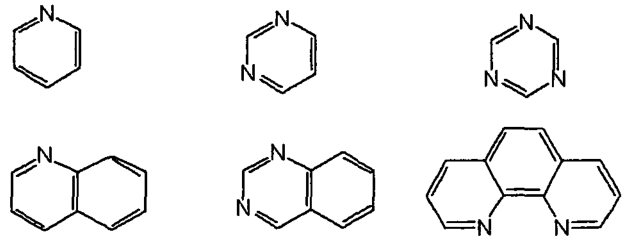

Group (b)

(provided that in each ring contained in the above Group (b), all of the o- and p-positions to the nitrogen atom are substituted by aromatic rings.)

Aromatic ring groups substituted for hydrogen atoms on the carbon atoms at the 2-, 4- and 6-positions in the same ring to a nitrogen atom, in the above Group (b), are not particularly limited. That is, they may be aromatic hydrocarbon groups or aromatic heterocyclic groups, but they are preferably aromatic hydrocarbon groups in view of superior durability against electrical oxidation.

The hole-relaxing material may, for example, be a compound having a structure represented by the following formula (1):

$$\left(A\right)_m \left(L\right)_l \left(B\right)_n \qquad (1)$$

(in the formula (1), A each independently is a $C_{1-30}$ hole-transporting unit, which may have a substituent, B each independently is a $C_{1-30}$ electron-transporting unit, which may have a substituent, L is a $C_{1-10}$ alkylene group, a $C_{2-10}$ alkenylene group or a $C_{6-30}$ bivalent aromatic hydrocarbon group, which may have a substituent, each of n and m is an integer of from 1 to 4, and l is an integer of from 0 to 3, provided that in the formula (1), when l, m or n is 2 or more, a plurality of L, A or B may be the same or different, respectively.)

The hole-transporting unit A and the electron-transporting unit B may be the same as those described above. The specific examples and preferred embodiments are also the same.

In the formula (1), L is an $C_{1-10}$ alkylene group, a $C_{2-10}$ alkenylene group or a $C_{6-30}$ bivalent aromatic hydrocarbon group.

The $C_{1-10}$ alkylene group is preferably a $C_{1-8}$ alkylene group, and its specific examples may, for example, be a methylene group, a 1,2-ethylene group, a 1,3-propyrene group, a 1,4-butylene group, a 1,5-pentylene group and a 1,8-octylene group, and from such a viewpoint that the preparation is simple, a methylene group or a 1,2-ethylene group is preferred.

The $C_{2-10}$ alkenylene group is preferably a $C_{2-6}$ alkenylene group, and its specific examples may, for example, be a 1,2-vinylene group, a 1,3-propenylene group, a 1,2-propenylene group and a 1,4-butenylene group. Further preferred is a vinylene group from such a viewpoint that the molecular planarity is improved so that the conjugation surface is broadened, whereby the charge may be more delocalized, and the stability of the compound will be improved.

The $C_{6-30}$ bivalent aromatic hydrocarbon group may, for example, be a bivalent group of a single ring or a 2- to 5-condensed ring, or a plurality thereof linked to one another. Here, the plurality is usually from 2 to 8, preferably from 2 to 5, in that the stability of the ring is thereby high.

Specific examples of such a bivalent organic hydrocarbon group may, for example, be bivalent aromatic hydrocarbon groups derived from e.g. a benzene ring, a naphthalene ring, a phenanthrene ring, an anthracene ring, a triphenylene ring, a chrysene ring, a naphthacene ring, a perylene ring and a coronene ring. Preferred is a bivalent group derived from a benzene ring, a naphthalene ring, an anthracene ring or a triphenylene ring, from the viewpoint of the high stability of the ring.

Further, preferred specific examples of the bivalent group of a single ring or a 2- to 5-condensed ring, or a plurality thereof linked to one another, as the $C_{6-30}$ bivalent aromatic hydrocarbon group, are represented by the following structural formulae S1 to S15, but it should be understood that the present invention is by no means limited to such examples.

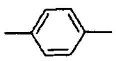
S1

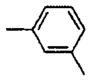
S2

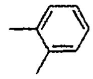
S3

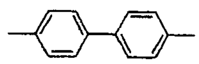
S4

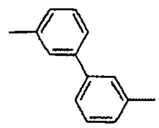
S5

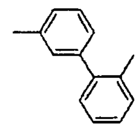
S6

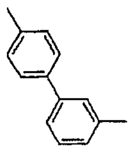
S7

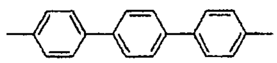
S8

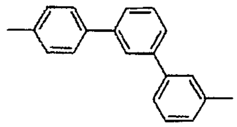
S9

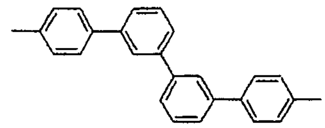
S10

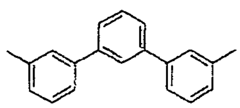
S11

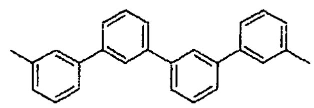
S12

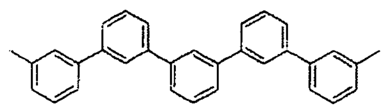
S13

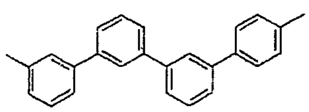
S14

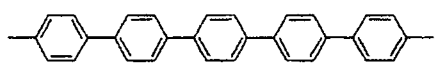
S15

Further, L may have a substituent, but is particularly preferably unsubstituted, whereby the stability against electrons will be improved, and the stability of the film will be improved by lowering the crystallinity of the molecule. On the other hand, when it has a substituent, the electrical stability of the compound will be improved, such being preferred.

A specific example of the substituent may, for example, be a $C_{1-20}$ alkyl group, a $C_{6-25}$ aromatic hydrocarbon group, $C_{3-20}$ aromatic heterocyclic group, a $C_{1-20}$ alkyloxy group, a $C_{3-20}$ (hetero)aryloxy group, a $C_{1-20}$ alkylthio group, a $C_{3-20}$ (hetero)arylthio group or a cyano group. Among them, an alkyl group is preferred from the viewpoint of the stability of the compound.

The $C_{1-20}$ alkyl group may, for example, be a methyl group, an ethyl group, a propyl group, an isopropyl group, a butyl group, an iso-butyl group, a sec-butyl group, a tert-butyl group, a hexyl group, an octyl group, a cyclohexyl group, a decyl group or an octadecyl group. Preferred is a methyl group, an ethyl group or an isopropyl group. A methyl group or an ethyl group is more preferred from the viewpoint of e.g. the availability or low cost of the material.

The $C_{6-26}$ aromatic hydrocarbon group may, for example, be a phenyl group, a naphthyl group such as a 1-naphthyl group or a 2-naphthyl group, a phenantyl group such as a 9-phenantyl group or a 3-phenantyl group, an anthryl group such as a 1-anthryl group, a 2-anthryl group or a 9-anthryl group, a naphthacenyl group such as a 1-naphthacenyl group or a 2-naphthacenyl group, a chrysenyl group such as a 1-chrysenyl group, a 2-chrysenyl group, a 3-chrysenyl group, a 4-chrysenyl group, a 5-chrysenyl group or a 6-chrysenyl group, a pyrenyl group such as a 1-pyrenyl group, a triphenylenyl group such as a 1-triphenylenyl group, a coronenyl group such as a 1-coronenyl group, or a biphenyl group such as a 4-biphenyl group or a 3-biphenyl group, and from the viewpoint of the stability of the compound, a phenyl

group, a 2-naphthyl group or a 3-biphenyl group is preferred, and a phenyl group is particularly preferred from the viewpoint of the purification efficiency of the compound.

The $C_{3-20}$ aromatic heterocyclic group may, for example, be a thienyl group such as a 2-thienyl group, a furyl group such as a 2-furyl group, an imidazolyl group such as a 2-imidazolyl group, a carbazolyl group such as a 9-carbazolyl group, a pyridyl group such as a 2-pyridyl group, or a triazinyl group such as a 1,3,5-triazin-2-yl group. Among them, a carbazolyl group, particularly a 9-carbazolyl group, is particularly preferred from the viewpoint of the stability.

The $C_{1-20}$ alkyloxy group may, for example, be a methoxy group, an ethoxy group, an isopropyloxy group, a cyctohexyloxy group or an octadecyloxy group.

The $C_{3-20}$ (hetero)aryloxy group may, for example, be a phenoxy group, a 1-naphthyloxy group, a 9-anthranyloxy group or a 2-thienyloxy group.

The $C_{1-20}$ alkylthio group may, for example, be a methylthio group, an ethylthio group, an isopropylthio group or a cyclohexylthio group.

The $C_{3-20}$ (hetero)arylthio group may, for example, be a phenylthio group, a 1-naphthylthio group, a 9-anthranylthio group or a 2-thienylthio group.

Further, the hole-relaxing material is preferably a compound having a structure represented by the formula (2) or (3):

$$B\left(L-A\right)_x \qquad (2)$$

$$A\left(L-B\right)_y \qquad (3)$$

(in the formulae (2) and (3), A each independently is a $C_{1-30}$ hole-transporting unit, which may have a substituent, B each independently is a $C_{1-30}$ electron-transporting unit, which may have a substituent, L is a $C_{1-10}$ alkylene group, a $C_{2-10}$ alkenylene group or a $C_{6-30}$ bivalent aromatic hydrocarbon group, which may have a substituent, and each of x and y is an integer of from 1 to 4, provided that in the formula (2), when x is an integer of 2 or more, a plurality of L-A may be the same or different, and in the formula (3) when y is an integer of 2 or more, a plurality of L-B may be the same or different.)

In the formulae (2) and (3), the hole-transporting unit A and the electron-transporting unit B may be the same as those mentioned above. The specific examples and preferred embodiments are also the same.

The alkylene group, the alkenylene group and the bivalent aromatic hydrocarbon group represented by L in the formulae (2) and (3) may be the same as those in the above formula (1).

Now, compounds which are preferably used as the hole-relaxing material, will be exemplified. They may be contained alone in the hole relaxation layer, or two or more of them may be contained in combination.

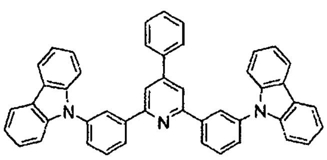
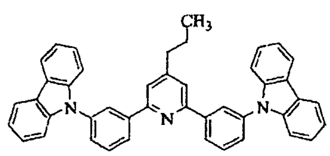
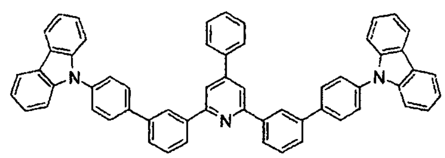
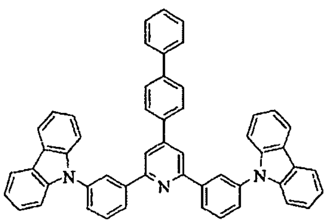
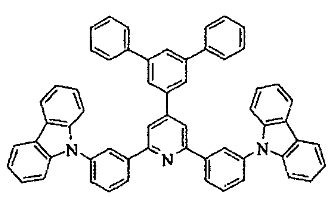
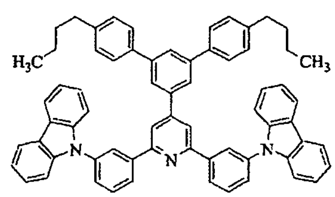

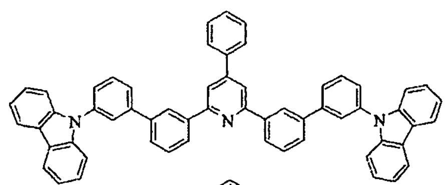

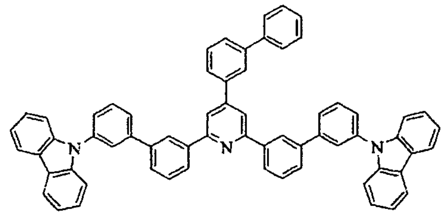

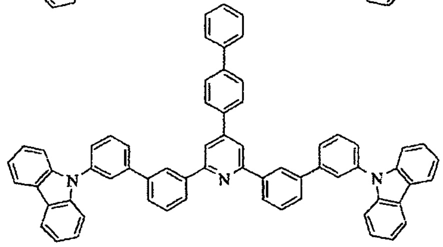

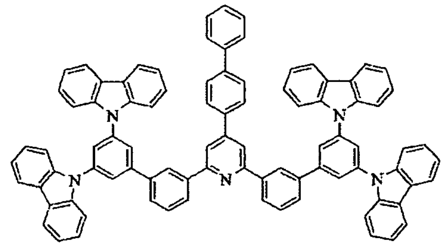

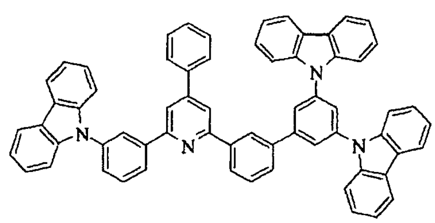

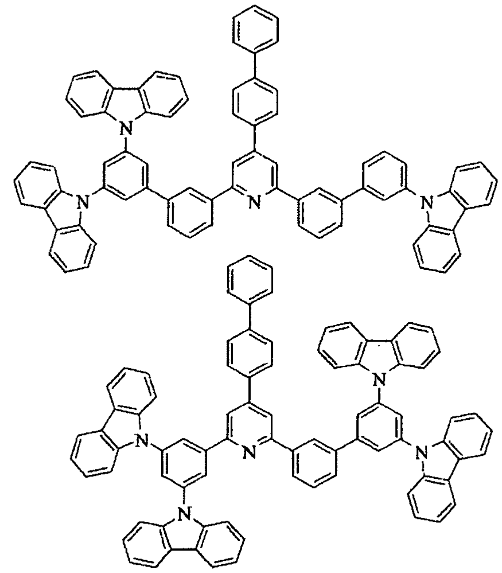

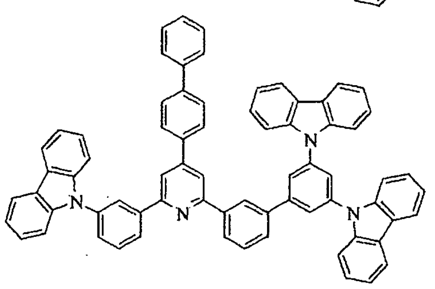

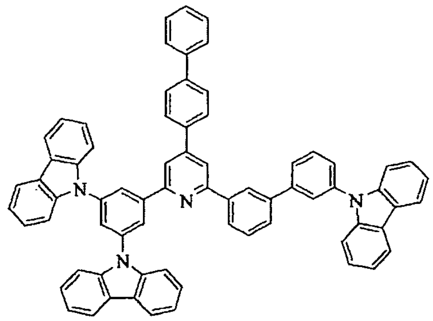

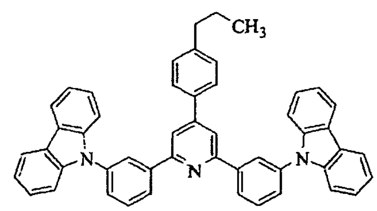

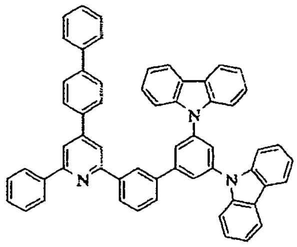

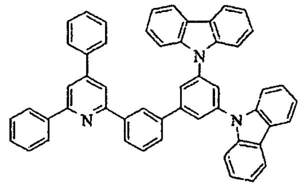

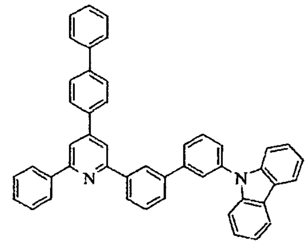

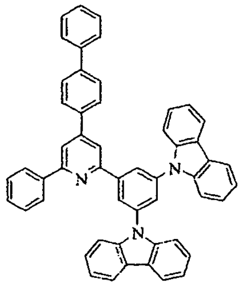

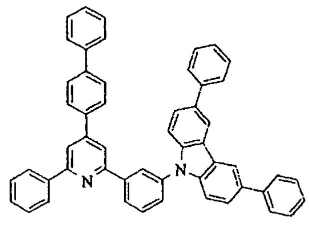

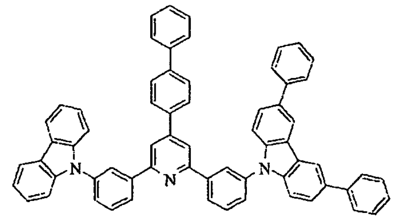

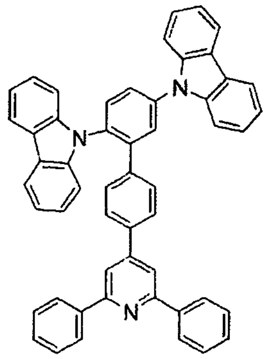

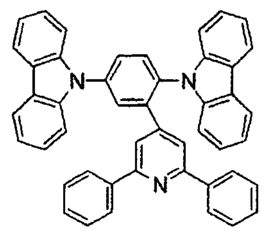

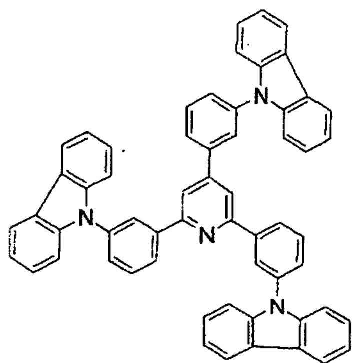

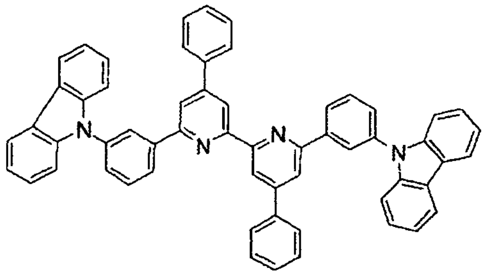

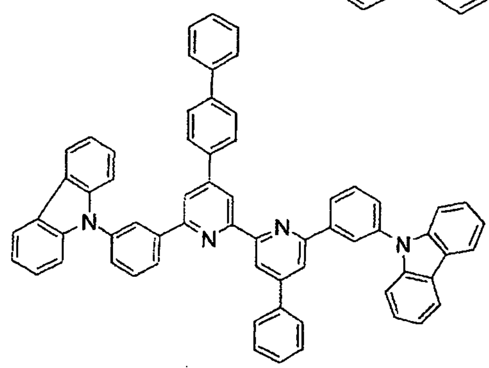

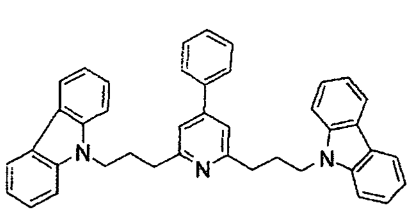

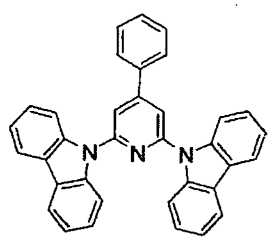

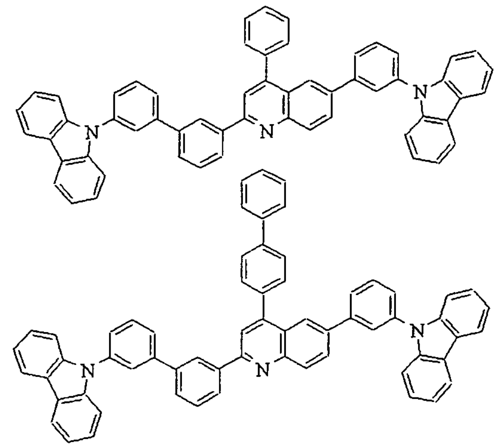

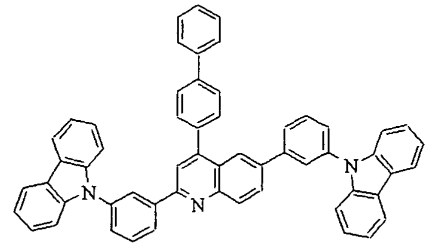

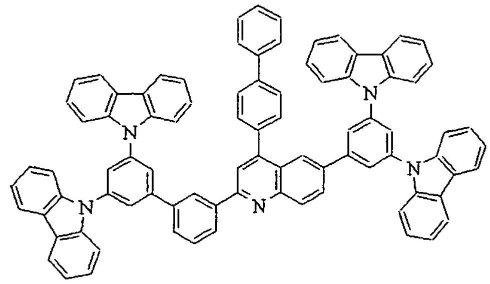

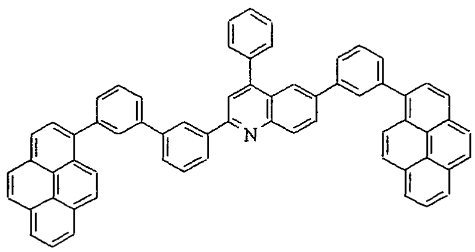

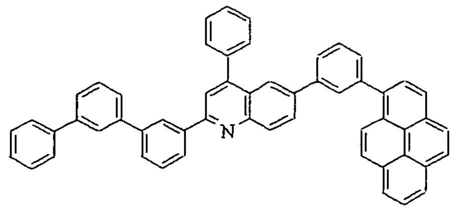

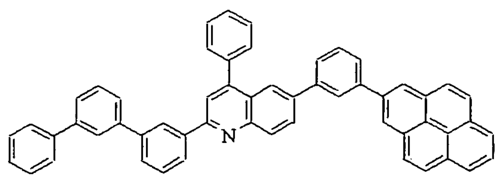

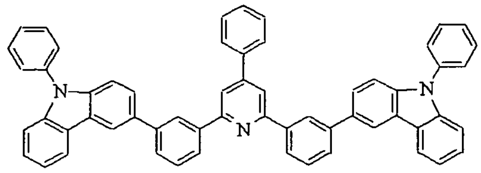

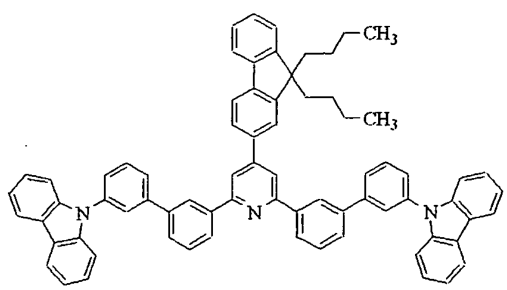

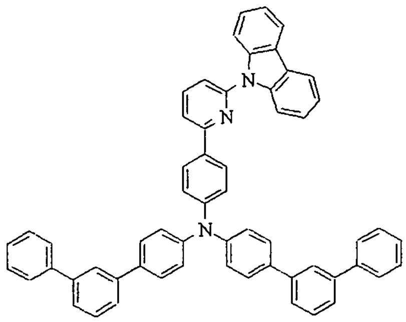 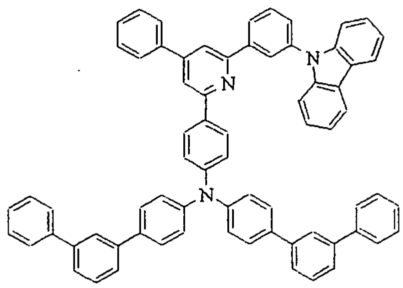

The molecular weight of the organic compound to be used as the hole-relaxing material is usually at most 10,000, preferably at most 5,000, more preferably at most 4,000, further preferably at most 3,000, and usually at least 100, preferably at least 200, more preferably at least 300, further preferably at least 400.

Within the above range, the compound has good heat resistance and is less likely to cause generation of a gas, and its purification is easy, and it can easily be highly purified, such being preferred.

<Light-emitting layer>

On a hole injection layer, or when a hole transport layer is provided, on such a hole transport layer, a light-emitting layer will be provided. The light-emitting layer is a layer which becomes a light-emitting source as excited by re-combination of holes injected from an anode and electrons injected from a cathode, between the electrodes having an electric field applied.

<Material of light-emitting layer>

The light-emitting layer in the present invention contains, as its constituting material, at least a material having a light-emitting nature (light-emitting material) and at the same time, contains a charge-transporting material. The light-emitting material may be used as a dopant material, and the charge-transporting material may be used as a host material. Here, the charge-transporting material may, for example, be a compound having a hole-transporting property (hole-transporting compound) and a compound having an electron-transporting property (electron-transporting compound).

In the light-emitting layer of the present invention, the content of the charge-transporting material is preferably at least 0.1 wt% and at most 100 wt%, more preferably at least 5 wt% and at most 95 wt%.

(Light-emitting material)

As the light-emitting material, at least one color among red, green and blue is preferably phosphorescence. More preferably, green and red are phosphorescence, and particularly preferably red is phosphorescence.

Further, for the purpose of improving the solubility in a solvent, it is preferred to lower the rigidity or symmetry of the molecule of the light-emitting material, or to introduce a lipophilic substituent such as an alkyl group.

As the light-emitting material of the present invention, a fluorescence-emitting material and/or a phosphorescence-emitting material may be used.

Among phosphorescence-emitting materials, examples of fluorochromes will be mentioned, but it should be understood that the fluorochromes are not limited to the following exemplified ones.

As fluorochromes presenting blue emission (blue fluorochromes), naphthalene, chrysene, perylene, pyrene, anthracene, coumarin, p-bis(2-phenylethenyl)benzene and their derivatives may, for example, be mentioned.

As fluorochromes presenting green emission (green fluorochromes), a quinacridone derivative, a coumarin derivative, and an aluminum complex such as $Al(C_9H_6NO)_3$ may, for example, be mentioned.

As fluorochromes presenting yellow emission (yellow fluorochromes), rubrene and perimidone derivatives may, for example, be mentioned.

As fluorochromes presenting red emission (red fluorochromes), a DCM(4-(dicyanomethylene)-2-methyl-6-(p-dimethylaminostyryl)-4H-pyran) compound, a benzopyran derivative, a rhodamine derivative, a benzothioxanthen derivative and an azabenzothioxanthen may, for example, be mentioned.

The phosphorescence-emitting material may, for example, be an organic metal complex containing a metal selected from Groups 7 to 11 of Long Form of the Periodic

Table (hereinafter, "Periodic Table" means "Long Form of the Periodic Table" unless otherwise specified).

As the metal selected from Groups 7 to 11 of the Periodic Table, preferably, ruthenium, rhodium, palladium, silver, rhenium, osmium, iridium, platinum or gold may, for example, be mentioned.

The ligand of the complex is preferably a ligand wherein a (hetero)aryl group is linked to e.g. pyridine, pyrazole or phenanthroline, such as a (hetero)aryl pyridine ligand or a (hetero)aryl pyrazole ligand, particularly preferably a phenylpyridine ligand or a phenylpyrazole ligand. Here, "(hetero)aryl" represents an aryl group or a heteroaryl group.

Specifically, a phosphorescence-emitting material may, for example, be tris(2-phenylpyridine)iridium, tris{2-(4-n-propylphenyl)pyridine}iridium, tris{2-(4-n-butylphenyl)isoquinoline}iridium, tris{2-(4-n-hexylphenyl)pyridine}iridium, tris{2-(4-n-hexylphenyl)isoquinoline}iridium, tris[5-methyl{3-(4'-n-hexylphenyl)phenyl}pyridine]iridium, tris(2-phenylpyridine)ruthenium, tris(2-phenylpyridine)palladium, bis(2-phenylpyridine)platinum, tris(2-phenylpyridine)osmium, tris(2-phenylpyridine)rhenium, octaethyl platinum porphyrin, octaphenyl platinum porphyrin, octaethyl palladium porphyrin, octaphenyl palladium porphyrin or their derivatives.

The molecular weight of the compound to be used as the light-emitting material is optional so long as it does not substantially impair the effects of the present invention, but it is usually at most 10,000, preferably at most 5,000, more preferably at most 4,000, further preferably at most 3,000 and usually at least 100, preferably at least 200, more preferably at least 300, further preferably at least 400. If the molecular weight of the light-emitting material is too small, the heat resistance may substantially be lowered, gas generation is likely to be caused, the film quality when formed into a film is likely to deteriorate, or a change in morphology of the organic EL element is likely to occur due to e.g. migration. On the other hand, if the molecular weight of the light-emitting material is too large, purification of the organic compound tends to be difficult, or it tends to take time at the time of dissolving it in a solvent.

Further, among the above-described light-emitting materials, any one type may be used alone, or two or more types may be used in an optional combination and ratio.

The content of the light-emitting material in the light-emitting layer is optional so long as the effects of the present invention are not substantially impaired, but it is usually at least 0.05 wt%, and usually at most 35 wt%. If the content of the light-emitting material is too small, the emission is likely to be non-uniform, and if it is too large, the luminous efficiency is likely to decrease. In the case where two or more light-emitting materials are used in combination, their total content is adjusted to be within the above range.

(Charge-transporting material)

The charge-transporting material may be a hole-transporting compound and an electron-transporting compound. In the present invention, at least one type of the charge-transporting material and at least one type of the hole-relaxing material, which are contained in the light-emitting layer, are the same organic compound. That is, in the light-emitting layer of the present invention, the same organic compound as the above hole-relaxing material is contained as one of the charge-transporting materials.

In the light-emitting layer of the present invention, the same organic compound as the above hole-relaxing material is incorporated as a charge-transporting material preferably in an amount of from 0.1 to 100 wt%, more preferably from 5 to 95 wt%.

That is, as the charge-transporting material, all of the organic compounds to be used as the above hole-relaxing material may be employed. That is, the above-mentioned compound having electron mobility and hole mobility may be used, and the compound represented by the above formula (1) is preferred, and the compound represented by the formula (2) or (3) is more preferred.

In the construction of the present invention, it is possible to employ a charge-transporting material having a large detectable amount of holes. Here, the detectable amount of holes is the amount of holes reaching the cathode side interface of the light-emitting layer, as confirmed by the measurement of ToF. In the measurement, the detectable amount of charge was calculated from the waveform obtained in the ToF measurement as disclosed in the above section of <Method for measuring charge mobility>, and this amount was taken as the detected number of carriers. At that time, the measurement was carried out by setting the energy of pulsed light to be about 20 $\mu$J. Thus the detectable total amounts of the respective charges of the holes and the electrons were obtained, and their ratio was taken to obtain a ratio in the number of detectable carriers. More specifically, as the charge-transporting material, it is preferred to employ one having a detectable amount of holes of usually at least $2.5\times10^{-10}$, preferably at least $3.0\times10^{-10}$, more preferably at least $3.5\times10^{-10}$, further preferably from $2.5\times10^{-10}$ to $1\times10^{-8}$, at the field density of 160 kV/cm (organic EL element B).

That is, a charge-transporting compound having such a large detectable amount of holes prevents holes, whereby holes are likely to stay at the interface between the light-emitting layer and a layer adjacent to the cathode side thereof, and there have been problems such that the material undergoes deterioration in the vicinity of the interface, and the driving life of the element tends to be short, and accordingly, it has been difficult to apply a conventional hole

blocking material. However, by adopting the construction of the present invention, it becomes possible to obtain an element having a long driving life even when a charge-transporting material having the above detectable amount of holes is employed.

Further, in the construction of the present invention, it is possible to employ a charge-transporting material having a large hole mobility.

More specifically, as the charge-transporting material, it is possible to employ one having a hole mobility of usually at least $1\times10^{-6}$ $cm^{-2}/V\cdot s$, preferably at least $1\times10^{-5}$ $cm^{-2}/V\cdot s$, more preferably at least $1\times10^{-4}$ $cm^{-2}/V\cdot s$, at 160 kV/cm.

That is, a charge-transporting material having such a large hole mobility, prevents holes, whereby holes are likely to stay at the interface between the light-emitting layer and a layer adjacent to the cathode side thereof, and there have been problems such that the material in the vicinity of the interface deteriorates, and the driving life of the element tends to be short, and accordingly, it has been difficult to apply a conventional hole-blocking material. However, by adopting the construction of the present invention, it becomes possible to obtain an element having a long driving life even when a charge-transporting material having the above hole mobility is employed.

Here, the hole mobility at 160 kV/cm is a value measured by the method disclosed in the above section of <Method for measuring charge mobility>.

Further, in the case where two or more charge-transporting materials are used, the detectable amount of holes or the hole mobility is a value of the detectable amount of holes or the hole mobility of a charge-transporting material having an ionization potential closer to the ionization potential of the layer adjacent to the cathode side of the light-emitting layer, among the charge-transporting materials.

Among the above-mentioned hole-relaxing materials, the charge-transporting material having such a large detectable amount of holes or such a large hole mobility, is preferably an organic compound containing at least one ring selected from the following Group (a) as the hole-transporting unit and at least one ring selected from the following Group (b) as the electron-transporting unit:

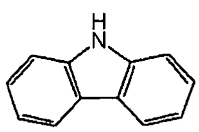
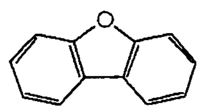
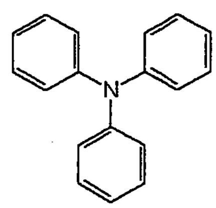
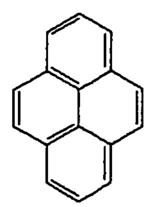

Group (a)

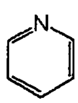
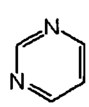
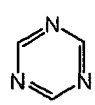
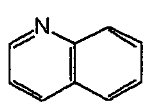
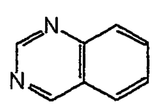
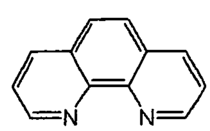

Group (b)

(provided that each of the rings contained in Group (b) has all of the o- and p-positions to each nitrogen atom substituted by aromatic rings.)

Compounds preferred as the charge-transporting material may be the same as the compounds to be used as the above-mentioned hole-relaxing material. More specifically, the compounds which are preferably employed as the hole-relaxing material, may be mentioned. They may be contained alone in the light-emitting layer, or two or more of them may be contained in combination.

Other hole-transporting compounds to be used as the charge-transporting material, may, for example, be, in addition to a low molecular weight hole-transporting compound to be used for the hole injection layer, an aromatic diamine containing at least two tertiary amines and having at least two condensed aromatic rings substituted on a

nitrogen atom as represented by 4,4'-bis[N-(1-naphthyl)-N-phenylamino]biphenyl (JP-A-5-234681), an aromatic amine compound having a star burst structure such as 4,4',4"-tris(1-naphthylphenylamino)triphenylamine (Journal of Luminescence, vol. 72-74, p. 985, 1997), an aromatic amine compound made of a tetramer of triphenylamine (Chemical Communications, p. 2175, 1996), a spiro compound such as 2,2',7,7'-tetrakis(diphenylamino)-9,9'-spirobifluorene (Synthetic Metals, vol. 91, p. 209, 1997), etc.

Here, in the light-emitting layer, such hole-transporting compounds may be used alone, or two or more of them may be used in an optional combination and ratio.

The content of the hole-transporting compound in the light-emitting layer is optional so long as the effects of the present invention are not substantially impaired, but it is usually preferably at least 0.1 wt% and at most 100 wt%, more preferably at least 5 wt% and at most 95 wt%. If the content of the hole-transporting compound is too small, it is likely to be susceptible to an influence of short circuiting, and if it is too large, the film thickness is likely to be non-uniform. Here, in the case where two or more hole-transporting compounds are used in combination, their total content is adjusted to be within the above range.

In the light-emitting layer, among charge-transporting materials, the low molecular weight electron-transporting compound may, for example, be 2,5-bis(1-naphthyl)-1,3,4-oxadiazole (BND), 2,5-bis(6'-(2',2"-bipyridyl))-1,1-dimethyl-3,4-diphenylsilole (PyPySPyPy), bathophenanthroline (BPhen), 2,9-dimethyl-4,7-diphenyl-1,10-phenanthroline (BCP, bathocuproin), 2-(4-biphenylyl)-5-(p-tert-butylphenyl)-1,3,4-oxadiazole (tBu-PBD) or 4,4'-bis(9-carbazol)-biphenyl (CBP). Here, in the light-emitting layer, such electron-transporting compounds may be used alone, or two or more of them may be used in an optional combination and ratio.

The content of the electron-transporting compound in the light-emitting layer is optional so long as the effects of the present invention are not substantially impaired, but it is usually preferably at least 0.1 wt% and at most 95 wt%, more preferably at least 0.5 wt% and at most 95 wt%. If the content of the electron-transporting compound is too small, it is likely to be susceptible to an influence of short circuiting, and if it is too large, the film thickness is likely to be non-uniform. Further, in the case where two or more electron-transporting compounds are used in combination, their total content is adjusted to be within the above range.

<Formation of light-emitting layer>

In the present invention, when a light-emitting layer is formed by a wet film-forming method, the above-mentioned materials are dissolved in a suitable solvent to prepare a light-emitting layer-forming composition, which is used for film formation to form a light-emitting layer.

As the solvent for light-emitting layer to be contained in the light-emitting layer-forming composition to form the light-emitting layer by the wet film-forming method, any optional solvent may be used so long as formation of a light-emitting layer is thereby possible.

The ratio of the solvent for light-emitting layer to the light-emitting layer-forming composition to form a light-emitting layer is optional so long as the effects of the present invention are not substantially impaired, but it is usually at least 0.01 wt% and at most 70 wt%. Further, in the case where two or more solvents are used as mixed, as the solvent for light-emitting layer, the total of such solvents is adjusted to be within this range.

Further, the solid content concentration of the light-emitting material, the hole-transporting compound, the electron-transporting compound, etc. in the light-emitting layer-forming composition is usually at least 0.01 wt% and at most 70 wt%. If such a concentration is too large, the film thickness is likely to be non-uniform, and if it is too small, the film is likely to have defects.

After subjecting the light-emitting layer-forming composition to wet film formation, the obtained coating film is dried to remove the solvent, whereby a light-emitting layer will be formed. The thickness of the light-emitting layer is optional so long as the effects of the present invention are not substantially impaired, but it is usually at least 3 nm, preferably at least 5 nm, and usually at most 200 nm, preferably at most 100 nm. If the thickness of the light-emitting layer is too thin, the film is likely to have defects, and if it is too thick, the driving voltage is likely to increase.

The organic EL element of the present invention is characterized basically by having the above-described hole relaxation layer and light-emitting layer. However, it is preferred that it further has a hole injection layer, a hole transport layer and an electron transport layer, and it is particularly preferred that these layers are laminated in the order of, from the anode side, a hole injection layer, a hole transport layer, a light-emitting layer, a hole relaxation layer and an electron transport layer.

Further, it is particularly preferred that the hole injection layer, the hole transport layer and the light-emitting layer are layers formed by a wet film forming method, and the hole relaxation layer and the electron transport layer are layers formed by a vapor deposition film-forming method. It is very advantageous from the viewpoint of the cost to form the light-emitting layer by a wet film-forming method, and it is preferred to form the hole relaxation layer and the electron transport layer by a vacuum vapor deposition method, whereby the light-emitting layer formed by such a wet film forming method will not be dissolved, and the film quality can be maintained uniformly.

In the present invention, the wet film-forming method is a method for forming a film in a wet system, such as a spin coating method, a dip coating method, a die coating method, a bar coating method, a blade coating method, a roll coating method, a spray coating method, a capillary coating method, an inkjet method, a screen printing method, a gravure printing method or a flexo printing method. Among such film-forming methods, a spin coating method, a spray coating method or an inkjet method is preferred, since such a method is suitable for the liquid property specific to a coating composition to be used for the organic EL element.

<Construction of organic EL element>

Now, the layered construction of the organic EL element of the present invention and a common method for its formation, etc. will be described with reference to Fig. 1.

Fig. 1 is a cross-sectional schematic view illustrating a structural example of the organic EL element of the present invention, and in Fig. 1, 1 represents a substrate, 2 an anode, 3 a hole injection layer, 4 a hole transport layer, 5 a light-emitting layer, 6 a hole relaxation layer, 7 an electron transport layer, 8 an electron injection layer, and 9 a cathode.

(Substrate)

The substrate 1 is one constituting a support for an organic EL element, and a quartz or glass plate, a metal plate or metal foil, or a plastic film or sheet, may, for example, be used. Particularly, a glass plate or a transparent plate of synthetic resin such as polyester, polymethacrylate, polycarbonate or polysulfone, is preferred. In the case where a synthetic resin plate is to be used, it is necessary to pay attention to the gas barrier property. If the gas barrier property of a substrate is too small, the organic EL element is likely to be deteriorated by external air passed through the substrate, such being undesirable. Therefore, it is one of preferred methods to provide a dense silicon oxide film or the like on at least one side of the synthetic resin substrate to secure a gas barrier property.

(Anode)

The anode 2 plays a role of hole injection into a layer on the light-emitting layer side.

Such an anode 2 is usually constituted by a metal such as aluminum, gold, silver, nickel, palladium or platinum, a metal oxide such as indium and/or tin oxide, a halogenated metal such as copper iodide, carbon black, or a conductive polymer such as poly(3-methylthiophene), polypyrrole or polyaniline.

The anode 2 may usually be formed by a sputtering method, a vacuum vapor deposition method or the like. Further, in the case where an anode 2 is formed by using fine particles of metal such as silver, fine particles of copper iodide or the like, fine particles of carbon black or conductive metal oxide, or fine powder of a conductive polymer, such fine particles or powder may be dispersed in a suitable binder resin solution and applied on a substrate 1 to form an anode 2. Further, in the case of a conductive polymer, it is possible to form an anode 2 by forming a thin film directly on a substrate 1 by electropolymerization or by applying the conductive polymer on a substrate 1 by coating (Appl. Phys. Lett., vol. 60, p. 2711, 1992).

The anode 2 is usually in a single layer structure, but may be made to have a laminated structure comprising a plurality of materials, as the case requires.

The thickness of the anode 2 varies depending upon the required transparency. When transparency is required, the transmittance of visible light is preferably adjusted to be usually at least 60%, preferably at least 80%. In such a case, the thickness of the anode 2 is usually at least 5 nm, preferably at least 10 nm and usually at most 1,000 nm, preferably at most 500 nm. When the anode 2 may be opaque, the thickness of the anode 2 is optional and may be the same as the substrate 1. Further, on such an anode 2, a different conductive material may be laminated.

For the purpose of improving the hole injection property by removing impurities deposited on the anode 2 or adjusting the ionization potential, it is preferred that the anode 2 surface is subjected to ultraviolet ray (UV)/ozone treatment, oxygen plasma treatment or argon plasma treatment.

(Hole injection layer)

The hole injection layer 3 is a layer to transport holes from the anode 2 to the light-emitting layer 5, and it is usually formed on the anode 2.

The method for forming the hole injection layer 3 according to the present invention is not particularly limited and may be a vacuum vapor deposition method or a wet film-forming method, but with a view to reducing dark spots, it is preferred to form the hole injection layer 3 by a wet film-forming method.

The thickness of the hole injection layer 3 is usually at least 5 nm, preferably at least 10 nm, and usually at most 1,000 nm, preferably at most 500 nm.

<Formation of hole injection layer by wet film-forming method>

In the case where the hole injection layer 3 is formed by wet film-forming, materials for the hole injection layer 3 are usually mixed with a suitable solvent (hole injection layer-forming solvent) to prepare a composition for film forming (composition for hole injection layer), and this hole injection layer-forming composition is applied on a layer (usually an anode) corresponding to a lower layer of the hole injection layer, by a suitable method, to form a film, followed by drying to form a hole injection layer 3.

(Hole-transporting compound)

The hole injection layer-forming composition usually contains a hole-transporting compound and a solvent as constituting materials for the hole injection layer.

The hole-transporting compound may be a high molecular compound or a monomer so long as it is a compound having a hole-transporting property which is commonly used for a hole injection layer of an organic EL element.

The hole-transporting compound is preferably a compound having an ionization potential of from 4.5 eV to 6.0 eV from the viewpoint of a barrier against charge injection from the anode 2 to the hole injection layer 3. Examples of the hole-transporting compound may, for example, be an aromatic amine compound, a phthalocyanine compound, a porphyrin compound, an oligothiophene compound, a polythiophene compound, a benzylphenyl compound, a compound having tertiary amines linked by a fluorene group, a hydrazone compound, a silazane compound, a silanamine compound, a phosphamine compound, a quinacridone compound, etc.

The hole-transporting compound to be used as the material for the hole injection layer 3 may contain one of these compounds alone or two or more of them. When two or more hole-transporting compounds are contained, the combination is optional, but it is preferred to use one or more aromatic tertiary amine polymer compounds and one or more other hole-transporting materials in combination.

Among them, preferred is an aromatic amine compound from the viewpoint of non crystallinity and the transmittance of visible light. Particularly preferred is an aromatic tertiary amine compound. Here, the aromatic tertiary amine compound is a compound having an aromatic tertiary amine structure and includes a compound having a group derived from an aromatic tertiary amine.

The type of the aromatic tertiary amine compound is not particularly limited, but a polymer compound (a polymer-type compound having repeating units) having a weight average molecular weight of at least 1,000 and at most 1,000,000, is further preferred from the viewpoint of uniform emission due to surface planarization effect. As a preferred example of the aromatic tertiary amine polymer compound, a polymer compound having repeating units represented by the following formula (1) may be mentioned.

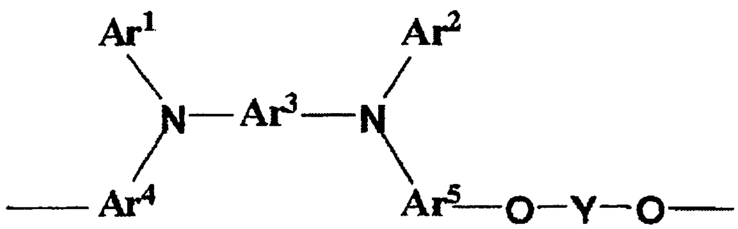

( I )

(In the formula (1), each of $Ar^1$ and $Ar^2$ which are independent of each other, is an aromatic hydrocarbon group which may have a substituent, or an aromatic heterocyclic group which may have a substituent. Each of $Ar^3$ to $Ar^5$ which are independent of one another, is an aromatic hydrocarbon group which may have a substituent, or an aromatic heterocyclic group which may have a substituent. Y is a linking group selected from the following group of linking groups. Further, among $Ar^1$ to $Ar^5$, two groups bonded to the same N atom may be bonded to each other to form a ring.)

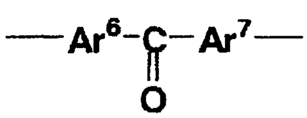
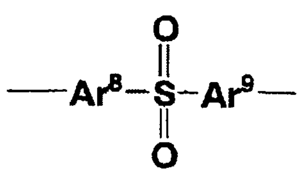
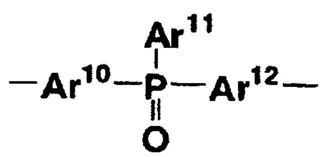

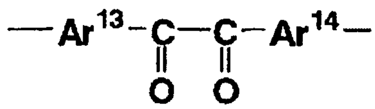 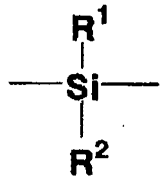 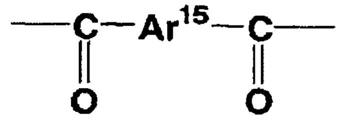

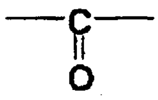 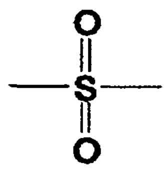 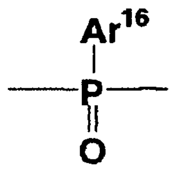

(In the above formulae, each of $Ar^6$ to $Ar^{16}$ which are independent of one another, is an aromatic hydrocarbon group which may have a substituent, or an aromatic heterocyclic group which may have a substituent, and each of $R^1$ and $R^2$ which are independent of each other, is a hydrogen atom or an optional substituent.)

The aromatic hydrocarbon group or the aromatic heterocyclic group for $Ar^1$ to $Ar^{16}$ is preferably a group derived from a benzene ring, a naphthalene ring, a phenanthrene ring, a thiophene ring or a pyridine ring, from the viewpoint of the solubility, heat resistance and hole injection/transport properties of the polymer compound. A group derived from a benzene ring or a naphthalene ring is more preferred.

The aromatic hydrocarbon group and the aromatic heterocyclic group for $Ar^1$ to $Ar^{16}$ may further have substituents. The molecular weight of the substituents is usually at most 400, preferably at most about 250. The substituent may, for example, be preferably an alkyl group, an alkenyl group, an alkoxy group, an aromatic hydrocarbon group or an aromatic heterocyclic group.

In the case where $R^1$ or $R^2$ is an optional substituent, such a substituent may, for example, be an alkyl group, an alkenyl group, an alkoxy group, a silyl group, a siloxy group, an aromatic hydrocarbon group or an aromatic heterocyclic group.

Specific examples of the aromatic tertiary amine polymer compound having repeating units represented by the formula (I) may, for example, be those disclosed in W02005/089024.

The concentration of the hole-transporting compound in the hole injection layer-forming composition is optional so long as the effects of the present invention are not substantially impaired, but from the viewpoint of uniformity of the film thickness, it is usually at least 0.01 wt%, preferably at least 0.1 wt%, more preferably at least 0.5 wt%, and usually at most 70 wt%, preferably at most 60 wt%, more preferably at most 50 wt%. If this concentration is too high, the film thickness is likely to be non-uniform, and if it is too low, the formed hole injection layer is likely to have defects.

(Electron-accepting compound)

The hole injection layer-forming composition preferably contains an electron-accepting compound as a constituting material for the hole injection layer. The electron-accepting compound is preferably a compound having an oxidizing power and having an ability to accept an electron from the above-described hole-transporting material, and specifically, it is preferably a compound having an electron affinity of at least 4 eV, more preferably a compound having an electron affinity of at least 5 eV.

Such an electron-accepting compound may, for example, be one or more compounds selected from the group consisting of a triaryl boron compound, a halogenated metal, a Lewis acid, an organic acid, an onium salt, a salt of an arylamine with a halogenated metal, and a salt of an arylamine with a Lewis acid. Further specifically, an onium salt substituted with an organic group, such as 4-isopropyl-4'-methyldiphenyl iodonium tetrakis(pentafluorophenyl) borate or triphenylsulfonium tetrafluoroborate (W02005/089024); a high-valent inorganic compound such as iron(III) chloride (JP-A-11-251067) or ammonium peroxodisulfate; a cyano compound such as a tetracyanoethylene; an aromatic boron compound such as tris(pentafluorophenyl)borane (JP-A-2003-31365); a fullerene derivative; or iodine, may, for example, be mentioned.

Such an electron-accepting compound is capable of improving the electrical conductivity of the hole injection layer by oxidizing the hole-transporting material.

The content of the electron-accepting compound in the hole injection layer or in the hole injection layer-forming composition is usually at least 0.1 mol%, preferably at least 1 mol%. However, it is usually at most 100 mol%, preferably at most 40 mol%.

(Other constituting materials)

As materials for the hole injection layer, other components may further be incorporated in addition to the above-described hole-transporting compound and electron-accepting compound, so long as the effects of the present invention are not substantially impaired. Examples of such other components may, for example, be various light-emitting materials, electron-transporting compounds, binder resins and coating-improving agents. Such other components may be used alone, or two or more of them may be used in an optical combination and ratio.

(Solvent)

Among solvents for the hole injection layer-forming composition to be used for the wet film-forming method, at least one type is preferably a compound capable of dissolving the constituting materials of the hole injection layer. The boiling point of the solvent is usually at least 110˚C, preferably at least 140˚C, particularly preferably at least 200˚C and usually at most 400˚C, particularly preferably at most 300˚C. If the boiling point of the solvent is too low, the drying speed is too fast, and the film quality is likely to deteriorate. On the other hand, if the boiling point of the solvent is too high, it is necessary to make the temperature of the drying step high, whereby other layers or glass substrate may be adversely affected. The solvent may, for example, be an ether solvent, an ester solvent, an aromatic hydrocarbon solvent or an amide solvent.

The etheric solvent may, for example, be an aliphatic ether such as ethylene glycol dimethyl ether, ethylene glycol diethyl ether or propylene glycol-1-monomethyl ether acetate (PGMEA); or an aromatic ether such as 1,2-dimethoxybenzene, 1,3-dimethoxybenzene, anisole, phenetole, 2-methoxytoluene, 3-methoxytoluene, 4-methoxytoluene, 2,3-dimethylanisole or 2,4-dimethylanisole.

The ester solvent may, for example, be an aromatic ester such as phenyl acetate, phenyl propionate, methyl benzoate, ethyl benzoate, propyl benzoate or n-butyl benzoate.

The aromatic hydrocarbon solvent may, for example, be toluene, xylene, cyclohexylbenzene, 3-isopropylbiphenyl, 1,2,3,4-tetramethylbenzene, 1,4-diisopropylbenzene, cyclohexylbenzene or methylnaphthalene.

The amide solvent may, for example, be N,N-dimethylformamide or N,N-dimethylacetamide.

As another solvent, dimethylsulfoxide may also be used.

These solvents may be used alone, or two or more of them may be used in an optional combination and ratio.

(Film-forming method)

After preparing the hole injection layer-forming composition, such composition is applied on a layer (usually an anode 2) corresponding to an underlayer of the hole injection layer 3 by wet film-forming to form a film, followed by drying, to form a hole injection layer 3.

The temperature in the film-forming step is preferably t least 10˚C and at most 50˚C in order to prevent formation of defects in the film due to formation of crystals in the composition.

The relative humidity in the film-forming step is not particularly limited so long as the effects of the present invention are not substantially impaired, but it is usually at least 0.01 ppm and usually at least 80%.

After the film formation, the film of the hole injection layer-forming composition is dried usually by heating. The heating means to be used in the heating step may, for example, be a clean oven, a hotplate, infrared rays, a halogen heater, microwave irradiation, etc. Among them, in order to present a heat uniformly over the entire film, a clean oven or a hotplate is preferred.

With respect to the heating temperature in the heating step, it is preferred to carry out the heating at a temperature of at least the boiling point of the solvent used for the hole injection layer-forming composition, so long as the effects of the present invention are not substantially impaired. In the case where the solvent used for the hole injection layer is a mixed solvent containing at least two types of solvents, the heating is preferably carried out at a temperature of at least the boiling point of at least one type of the solvents. In consideration of the rise of the boiling point of the solvent, in the heating step, it is preferred to carry out the heating at a temperature of preferably at least 120˚C and preferably at most 410˚C.

In the heating step, so long as the heating temperature is at least the boiling point of the solvent for the hole injection layer-forming composition, and no adequate insolubilization of the coating film takes place, the heating time is not particularly limited, but it is preferably at least 10 seconds and usually at most 180 minutes. If the heating time is too long, components of other layers tend to diffuse, and if it is too short, the hole injection layer tends to be non-uniform. The heating may be carried out dividedly in twice.

<Formation of hole injection layer by vacuum vapor deposition method>

In the case where the hole injection layer 3 is to be formed by vacuum vapor deposition, one or more constituting materials for the hole injection layer 3 (the hole-transporting compound, the electron-accepting compound, etc.) are put in crucibles set in a vacuum container (in the case where two or more materials are used, they are put in the respective crucibles), and the interior of the vacuum container is evacuated to a level of about $10^{-4}$ Pa by a suitable vacuum pump. Then, the crucible is heated (in the case where two or more materials are used, their respective crucibles are heated) for evaporation while controlling the amount of evaporation (when two or materials are used, they are evaporated while controlling the amounts of their evaporation independently) to form a hole injection layer 3 on an anode 2 of the substrate disposed to face the crucible(s). Here, when two or more materials are to be used, it is also possible that their mixture may be put into a crucible and heated and evaporated to form a hole injection layer 3.

The vacuum degree at the time of the vapor deposition is not limited so long as the effects of the present invention are not substantially impaired, but it is usually at least $0.1\times10^{-6}$ Torr ($0.13\times10^{-4}$ Pa) and usually at most $9.0\times10^{-6}$ Torr ($12.0\times10^{-4}$ Pa). The vapor deposition rate is not particularly limited so long as the effects of the present invention are not substantially impaired, but it is usually at least 0.1 Å/sec and usually at most 5.0 Å/sec. The film-forming temperature at the time of the vapor deposition is not limited so long as the effects of the present invention are not substantially impaired, but it is preferably at least 10˚C and preferably at most 50˚C.

[Hole transport layer]

The method for forming the hole transport layer 4 according to the present invention may be a vacuum vapor deposition method or a wet film-forming method, and is not particularly limited, but with a view to reducing dark spots, it is preferred to form it by a wet film-forming method.

When a hole injection layer is present, the hole transport layer 4 may be formed on the hole injection layer 3, and when no hole injection layer 3 is present, it may be formed on the anode 2. Further, the organic EL element of the present invention may have a construction omitting such a hole transport layer.

The material to form the hole transport layer 4 is preferably a material which has a high hole-transporting property and is capable of efficiently transporting injected holes. For this purpose, it is preferred that the ionization potential is small, the transparency to visible light is high, the hole mobility is large, the stability is excellent, and an impurity to form a trap is hardly formed during the production or use. Further, in many cases, it is in contact with the light-emitting layer 5, and therefore it is desired not to quench the emission from the light-emitting layer 5 or not to reduce the efficiency by forming an exciplex with the light-emitting layer 5.

Such a material for the hole transport layer 4 may be a material which has been commonly used as a constituting material for a hole transport layer, and for example, one exemplified as the hole-transporting compound to be used for the above-described hole injection layer 3 may be mentioned. Further, it may, for example, be an aromatic diamine containing at least two tertiary amines and having at least two condensed aromatic rings substituted on a nitrogen atom, as represented by 4,4'-bis[N-(1-naphthyl)-N-phenylamino]biphenyl (JP-A-5-234681), an aromatic amine compound having a star burst structure such as 4,4',4"-tris(1-naphthylphenylamino)triphenylamine (J. Lumin., vol. 72-74, p. 985, 1997), an aromatic amine compound made of a tetramer of triphenylamine (Chem. Commun., p. 2175, 1996), a spiro compound such as 2,2',7,7'-tetrakis(diphenylamino)-9,9'-spirobifluorene (Synth. Metals, vol. 91, p. 209, 1997) or a carbazole derivative such as 4,4'-N,N'-dicarbazolebiphenyl. Further, it may, for example, be a polyvinylcarbazole, a polyvinyltriphenylamine (JP-A-7-53953), or a polyarylene ether sulfone containing tetraphenylbenzidine (Polym. Adv. Tech., vol. 7. P. 33, 1996).

In the case where the hole transport layer 4 is to be formed by a wet film-forming method, in the same manner as in the formation of the above hole injection layer 3, a hole transport layer-forming composition is prepared and then formed into a film by wet film formation, followed by heating and drying.

The hole transport layer-forming composition contains a solvent in addition to the above-described hole-transporting compound. The solvent to be used is the same as one used for the above hole injection layer-forming composition. Further, the film forming conditions, the heating and drying conditions, etc. may be the same as in the formation of the hole injection layer 3.

Also in the case where the hole transport layer is to be formed by a vacuum vapor deposition method, the film forming conditions, etc. may be the same as in the formation of the above hole injection layer 3.

The hole transport layer may contain various light-emitting materials, electron-transporting compounds, binder resins, coating property-improving agents, etc., in addition to the above hole-transporting compound.

The hole transport layer 4 may further be a layer formed by crosslinking a crosslinkable compound. Such a crosslinkable compound is a compound having a crosslinkable group and forms a network polymer compound by crosslinking.

Such a crosslinkable group may, for example, be a cyclic ether such as oxetane or epoxy; an unsaturated

double bond such as a vinyl group, a trifluorovinyl group, a styryl group, an acryl group, a methacryloyl or cinnamoyl; or benzocyclobutane.

The crosslinkable compound may be a monomer, an oligomer or a polymer. the crosslinkable compound may have one type only, or may have two or more types in an optional combination and ratio.

Such a crosslinkable group may, for example, be a cyclic ether such as an oxetane group or an epoxy group; an unsaturated double bond such as a vinyl group, a trifluorovinyl group, a styryl group, an acryl group, a methacryloyl group or a cinnamoyl group; or a benzocyclobutene group.

As the crosslinkable compound, it is preferred to employ a hole-transporting compound having a crosslinkable group. The hole-transporting compound may, for example, be a nitrogen-containing aromatic compound derivative such as a pyridine derivative, a pyrazine derivative, a pyrimidine derivative, a triazine derivative, a quinoline derivative, a phenanthroline derivative, a carbazol derivative, a phthalocyanine derivative or a porphyrin derivative; a triphenylamine derivative; a silole derivative; an oligothiophene derivative, a condensed polycyclic aromatic derivative or a metal complex. Among them, a nitrogen-containing aromatic derivative such as a pyridine derivative, a pyrazine derivative, a pyrimidine derivative, a triazine derivative, a quinoline derivative, a phenanthroline derivative or a carbazol derivative; a triphenylamine derivative, a silole derivative, a condensed polycyclic aromatic derivative a metal complex or the like is preferred, and particularly, a triphenylamine derivative is more preferred.

To crosslink the crosslinkable compound to form a hole transport layer 4, usually, a hole transport layer-forming composition having a crosslinkable compound dissolved or dispersed in a solvent, is prepared and formed into a film by wet film formation, followed by crosslinking.

The hole transport layer-forming composition may contain an additive to promote the cross-linking reaction in addition to the cross-linkable compound. The additive to promote the crosslinking reaction may, for example, be a polymerization initiator or a polymerization accelerator such as an alkylphenone compound, an acylphosphineoxide compound, a metallocene compound, an oxime ester compound, an azo compound or an onium salt; or a photosensitizer such as a condensed polycyclic hydrocarbon, a porphyrin compound or a diarylketone compound.

Further, it may further contain a coating property-improving agent such as a leveling agent or a defoaming agent; an electron accepting compound; or a binder resin.

The hole transport layer-forming composition contains the cross-linkable compound usually in an amount of at least 0.01 wt%, preferably at least 0.05 wt%, more preferably at least 0.1 wt%, and usually at most 50 wt%, preferably at most 20 wt%, further preferably at most 10 wt%.

The hole transport layer-forming composition containing the crosslinkable compound in such a concentration is formed into a film on an under layer (usually a hole injection layer 3), followed by heating and/or irradiation with an electromagnetic energy such as light, to crosslink the crosslinkable compound thereby to form a network polymer compound.

The conditions such as the temperature, humidity, etc. at the time of the film formation are the same as at the time of the wet film formation of the above hole injection layer 3.

The means for heating after the film formation is not particularly limited, but may, for example, be heat-drying or reduced pressure-drying. In the case of the heat-drying, the heating temperature condition is usually at least 120˚C and preferably at most 400˚C.

The heating time is usually at least 1 minute and preferably at most 24 hours. The heating means is not particularly limited, and a means of heating the laminate having a formed film layer on a hotplate or in an oven may be employed. For example, it is possible to employ a condition such that heating is carried out on a hotplate at a temperature of at least 120˚C for at least one minute.

In the case of irradiation with an electromagnetic energy such as light, a method for irradiation directly by means of an ultraviolet, visible light or infrared light source such as an ultrahigh pressure mercury lamp, a high pressure mercury lamp, a halogen lamp or an infrared lamp, or a method for irradiation by means of a mask aligner or conveyer type irradiation apparatus having the above light source built in. For irradiation with an electromagnetic energy other than light, a method for irradiation by means of an apparatus to irradiate with microwaves generated by e.g. a magnetron, i.e. a microwave, may be mentioned. The irradiation time is preferably set to satisfy a necessary condition to lower the melting of the film, and the irradiation is carried out usually at least 0.1 second and preferably at most 10 hours.

The heating and the irradiation with an electromagnetic energy such as light may respectively be carried out alone, or in combination. When they are used in combination, their order is not particularly limited.

The thickness of the hole transport layer thus formed, is usually at least 5 nm, preferably at least 10 nm, and usually at most 300 nm, preferably at most 100 nm.

{Electron transport layer}

Between the light-emitting layer 5 and the after-mentioned electron injection layer 8, an electron transport layer 7 may be provided.

The electron transport layer 7 is provided for the purpose of further improving the luminous efficiency of the element, and it is formed from a compound which is capable of transporting electrons injected from the cathode 9 efficiently to the direction of the light-emitting layer 5, between electrodes having an electric field given.

As the electron-transporting compound to be used for the electron transport layer 7, a compound is usually employed which has a high efficiency for injection of electrons from the cathode 9 or the electron injection layer 8 and which has a high electron mobility so that it is capable of efficiently transporting the injected electrons. The compound which satisfies such conditions may, for example, be a metal complex such as an aluminum complex of 8-hydroxyquinoline (JP-A-59-194393), a metal complex of 10-hydroxybenzo[h]quinoline, an oxadiazole derivative, a distyrylbiphenyl derivative, a silole derivative, a 3-hydroxyflavone metal complex, a 5-hydroxyflavone metal complex, a benzoxazole metal complex, a benzothiazole metal complex, trisbenzimidazolyl benzene (U.S. Patent No. 5,645,948), a quinoxaline compound (JP-A-6-207169), a phenanthroline derivative (JP-A-5-331459), 2-t-butyl-9,10-N,N'-dicyanoanthraquinonediimine, a n-type hydrogenated amorphous silicon carbide, n-type zinc sulfide, or a n-type zinc cerenate.

Such materials for the electron transport layer 7 may be used alone, or two or more of them may be used in an optional combination and ratio.

The method for forming the electron transport layer 7 is not particularly limited. Accordingly, it may be formed by a wet film-forming method, a vapor deposition method or another method.

The thickness of the electron transport layer 7 is optional so long as the effects of the present invention are not substantially impaired, but it is usually at least 1 nm, preferably at least 5 nm, and usually at most 300 nm, preferably at most 100 nm.

{Electron injection layer}

The electron injection layer 8 plays a role to efficiently inject electrons injected from the cathode 9 into the light-emitting layer 5. To carry out the electron injection efficiently, the material to form the electron injection layer 8 is preferably a metal having a low work function. As specific examples, an alkali metal such as sodium or cesium, an alkaline earth metal such as barium or calcium, etc. may be used, and the film thickness is usually at least 0.1 nm and at most 5 nm.

Further, it is preferred to dope an alkali metal such as sodium, potassium, cesium, lithium or rubidium to an organic electron-transporting compound represented by a nitrogen-containing heterocyclic compound such as bathophenanthroline or a metal complex such as an aluminum complex of 8-hydroxyquinoline (JP-A-10-270171, JP-A-2002-100478, JP-A-2002-100482, etc.), whereby the electron injection/transport properties can be improved, and an excellent film quality can also be obtained. In such a case, the film thickness is usually at least 5 nm, preferably at least 10 nm, and usually at most 200 nm, preferably at most 100 nm.

Such materials for the electron injection layer 8 may be used alone, or two or more of them may be used in an optional combination and ratio.

The method for forming the electron injection layer 8 is not limited. Accordingly, it may be formed by a wet film-forming method, a vapor deposition method or another method.

{Cathode}

The cathode 9 plays a role to inject electrons to a layer (an electron injection layer 8 or a light-emitting layer 5) on the light-emitting layer 5 side.

As the material for the cathode 9, a material to be used for the above anode 2 may be employed, but in order to carry out electron injection efficiently, a metal having a low work function is preferred, and a proper metal such as tin, magnesium, indium, calcium, aluminum or silver, or an alloy thereof, may, for example, be used. As a specific example, an alloy electrode having a low work function such as a magnesium/silver alloy, a magnesium/indium alloy or an aluminum/lithium alloy may be mentioned.

Such materials for the cathode 9 may be used alone, or two or more of them may be used in an optional combination and ratio.

The thickness of the cathode 9 is usually the same as the anode 2.

Further, for the purpose of protecting the cathode 9 made of a metal having a low work function, it is preferred to further laminate thereon a metal which has a high work function and which is stable against atmospheric air, whereby the stability of the element will be increased. For this purpose, a metal such as aluminum, silver, copper, nickel, chromium, gold or platinum may, for example, be used. These materials may be used alone, or two or more of them may be used in an optional combination and ratio.

{Other layers}

The organic EL element of the present invention may have another construction within a range not to depart

from the concept of the present invention.

For example, it may have an optional layer in addition to the above-described layers, between the anode 2 and the cathode 9, or an optional layer may be omitted, so long as its performance is not impaired.

Further, it is also possible to constitute the organic EL element of the present invention by laminating constituting elements other than the substrate between two substrates, of which at least one has transparency.

Further, it may take a structure wherein a constituting unit other than the substrate (emission unit) is overlaid one on another in multiple stages (structure wherein a plurality of emission units are laminated). In such a case, it is preferred to provide a carrier generation layer (CGL) made of e.g. vanadium pentaoxide ($V_2O_5$) instead of the interface layer (in the case where the anode is an ITO and the cathode is Al, such two layers) between the respective stages (between emission units), whereby a barrier between the stages is reduced, such being preferred from the viewpoint of the luminous efficiency and the driving voltage.

Further, the organic EL element of the present invention may be constructed as a single organic EL element, or may be applied to a construction wherein a plurality of organic EL elements are disposed in an array or to a construction wherein the anode and the cathode are disposed in an X-Y matrix form.

Further, in the above-described respective layers, a component other than those described as materials may be contained so long as the effects of the present invention are not substantially impaired.

In an organic light-emitting device having red, green and blue organic EL elements, if the above organic EL element A or B is used as at least one of the red, green and blue organic EL elements, it is possible to obtain an organic light-emitting device having a long life and having an increase of the voltage suppressed. It is more preferred to employ the above organic EL element A or B for all of the red, green and blue organic EL elements.

<Organic EL element C>

The organic EL element C of the present invention is an organic EL element corresponding to the above organic EL element A wherein the light-emitting layer contains at least two light-emitting materials.

In the case of the organic EL element C of the present invention i.e. the element wherein the light-emitting layer contains at least two light-emitting materials, it is effective to use the hole-relaxing material in the present invention for the following reason.

As the organic EL element C, it is preferred that at least two light-emitting materials are contained in one light-emitting layer, the emission spectrum of the light-emitting element has at least two peak wavelengths, and when the maximum emission intensity among the peak wavelengths is taken as 1, the emission intensity of the rest of the peak wavelengths is at least 0.1.

In the case where the organic EL element C is designed for yellow emission, a method may, for example, be adopted wherein a green-emitting material and a red-emitting material are incorporated as light-emitting materials to the light-emitting layer.

Further, this organic EL element C may be applied for white emission. For such white emission, a method may be adopted wherein in the light-emitting layer, as the light-emitting materials, three colors of the blue-emitting material, green-emitting material and red-emitting material are combined, or a method may be adopted wherein a certain color is combined with a color complementary thereto. Further, the light-emitting layer contains a charge transport material, and the charge transport material is selected in consideration of the ionization potential and the electron affinity of the light-emitting material having the largest energy gap among light-emitting materials contained in the light-emitting layer.

Hereinafter, "large or small" of ionization potential represents "large" or "small" of the absolute value of the ionization potential.

The organic EL element C of the present invention contains at least two light-emitting materials in the light-emitting layer.

In the light-emitting layer containing at least two light-emitting materials, holes injected into the light-emitting layer are likely to accumulate in a light-emitting material having the smallest ionization potential. If the light-emitting material is in a radical cation state for a long time by holes, the light-emitting material will be in an unstable state for a long time, whereby deterioration of the light-emitting material is accelerated.

On the other hand, in the case of an organic EL element having a light-emitting layer containing one type of light-emitting material (monochromatic light-emitting organic EL element), the difference in the ionization potential between the charge transport material and the light-emitting material is selected to be smaller than the difference in the ionization potential between the largest charge-transporting material and the light-emitting material in the above-described organic EL element A.

That is, in the monochromatic light-emitting organic EL element, holes injected into the light-emitting layer tend to easily accumulate in the charge-transporting material than the light-emitting material, as compared with the organic EL element C. This means that deterioration of the light-emitting material by holes tends to be small.

From the foregoing, in the organic EL element C, the effect by permitting a small amount of holes to escape

is larger. That is, the effect of employing the hole-relaxing material in the present invention is large.

[Light-emitting layer]

The organic EL element C in the present invention contains at least two light-emitting materials.

The light-emitting materials to be incorporated are suitably selected from known materials depending upon the desired emission color of the organic EL element.

For example, in the case where the organic EL element C is intended for yellow emission, a method of incorporating a red-emitting material and a green-emitting material may be mentioned. In such a case, the ratio in the content (weight ratio) of the red-emitting material to the green-emitting material is suitably selected depending upon the desired color tone of the yellow emission, but {green-emitting material:red-emitting material} is preferably e.g. {100:20 to 100:1}.

Further, in the case where the organic EL element C is intended for white emission, a method of incorporating a red-emitting material, a blue-emitting material and a green-emitting material may be mentioned. In such a case, the ratio in the content (weight ratio) of the blue-emitting material, the green-emitting material and the red-emitting material is suitably selected depending upon the desired color tone of the white emission, but, for example, {blue-emitting material: green-emitting material:red-emitting material} is preferably {100:(50-5):(10-0.05)}.

The light-emitting layer of the organic EL element of the present invention contains one or more charge-transporting materials. To a light-emitting layer containing at least two light-emitting materials, a charge-transporting material is further incorporated, but the charge-transporting material at that time is selected to be one having an ionization potential smaller than the ionization potential of at least one type of light-emitting material. Further, in the present invention, at least one type of the charge-transporting material and at least one type of the hole-relaxing material in the light-emitting layer are the same compound, whereby formation of a charge-injection barrier accompanied by the formation of a heterobond at the interface between the light-emitting layer and the hole relaxation layer is relaxed, so that holes tend to easily flow.

The organic EL element C is the same as the organic EL element A except that at least two light-emitting materials are contained in the light-emitting layer.

<Organic EL element D>

The organic EL element D of the present invention is an organic EL element characterized in that in the above-mentioned organic EL element A, the light-emitting layer is made of at least two layers which contain light-emitting materials different from one another.

In the organic EL element D, it is effective to use the hole-relaxing material in the present invention and to ensure that in the light-emitting layer, at least one type of the charge-transproting material contained in a layer adjacent to the hole relaxation layer and at least one type of the hole-relaxing material are the same compound, for the following reason.

The organic EL element is known to cause a shift in the energy level of the ionization potential and the electron affinity dependent on the direction of applied voltage and the species of the material at the junction interface (hetero interface) of the different organic materials, upon application of a voltage (e.g. "ORGANIC EL MATERIAL AND DISPLAY", chapter 4, published by CMC). This indicates that the organic EL element during its driving always has a charge injection barrier at the bonded interface between the respective organic layers. Further, if the structure of the element is a multilayered laminate structure, the number of hetero interfaces will increase as the number of laminated layers increases, which indicates that holes are likely to accumulate at the interfaces of the respective layers.

Therefore, as compared with a case where the light-emitting layer is a single layer, in the case where the light-emitting layer is made of at least two layers, more multiple charge injection barriers are likely to form, and an influence such as shortening of the life by deterioration of the material due to accumulation of holes, or a decrease in the luminous efficiency due to extinction of excitons is considered to be larger.

That is, the construction of the organic EL device D is capable of reducing formation of hetero interfaces where accumulation of holes are likely to occur, as compared with a conventional monochromatic element, and thus the effect of adopting such a construction in the present invention is large.

[Light-emitting layer]

In the organic EL element D of the present invention, the light-emitting layer comprises at least two layers, and the respective layers contain different light-emitting materials.

In the organic EL element D, depending upon the desired emission color, each layer of the light-emitting layer may contain two or more light-emitting materials. For example, a layer nearest to the anode among the light-emitting layers may be a layer containing two light-emitting materials, and an adjacent layer on the cathode side of such a layer

may be a layer containing one light-emitting material. Otherwise, the construction may be opposite to the above.

For example, in the case where the organic EL element D is designed for white emission, the light-emitting layer may be made to comprise from the anode side, a layer containing a red-emitting material and a green-emitting material, and a layer containing a blue-emitting material. Otherwise, by an opposite construction, i.e. by letting the light-emitting layer comprise, from an anode side, a layer containing a blue-emitting material and a layer containing a red-emitting material and a green-emitting material, white emission may be attained.

The organic EL element D is the same as the above-mentioned organic EL element A except that the light-emitting layer comprises such at least two layers.

The organic EL elements C and D of the present invention are basically characterized in that they have the above-described hole relaxation layer and light-emitting layer. However, the red, green and blue organic EL elements preferably further have a hole injection layer, a hole transport layer and an electron transport layer, and these layers are particularly preferably laminated from the anode side in the order of a hole injection layer, a hole transport layer, a light-emitting layer, a hole relaxation layer and an electron transport layer. These respective layers and their forming method may be the same as those disclosed in the section of the above <Organic EL element A>. Further, preferred ones are also the same.

For an organic light-emitting device of the present invention, the above organic EL element A, B, C or D may be employed. The organic light-emitting device includes an organic EL display device and an organic EL illumination.

<Organic EL display device>

The organic EL element of the present invention is used for an organic EL display device. By using the organic EL element obtainable by the present invention, an organic EL display device may be formed, for example, by a method disclosed in "ORGANIC EL DISPLAY" (published by Ohmsha, Ltd., on August 20, 2004, edited by Shizuo Tokito, Chihaya Adachi and Hideyuki Murata).

<Organic EL illumination>

The organic EL illumination of the present invention is one employing the above-described organic EL element of the present invention. The organic EL illumination of the present invention is not particularly limited with respect to the type or structure, and it may be assembled in accordance with a common method by using the organic EL element of the present invention.

EXAMPLES

The present invention will be described in further detail with reference to Examples, but it should be understood that the present invention is by no means limited to the following Examples.

Here, Examples 1 to 3 correspond to the organic EL element A of the present invention or the organic EL element B of the present invention; Example 4 to the organic EL element C of the present invention; and Example 5 to the organic EL element D of the present invention.

[REFERENCE EXAMPLE 1]

An organic EL element having the structure shown in Fig. 1 was prepared by the following method.

(Preparation of ITO substrate)

An indium · tin oxide (ITO) transparent conductive film deposited in a thickness of 150 nm on a glass substrate 1 (a sputter-deposited product, sheet resistance: 15 Ω) was subjected to patterning in stripes with a width of 2 mm by means of a usual photolithography technique and hydrochloric acid etching to form an anode 2.

(Pre-treatment)

The substrate having the anode patterned as described above (ITO substrate) was subjected to cleaning in the order of ultrasonic cleaning by a surfactant, water washing by pure water and ultrasonic cleaning by isopropyl alcohol, then dried by compressed air and finally subjected to ultraviolet ray ozone cleaning for 1 minute.

(Film formation of hole injection layer)

Then, a hole injection layer 3 was formed by a wet film-forming method as follows. As the material for the hole injection layer 3, a composition having 2 wt% of a polymer having a repeating structure of the following formula (1-2) (weight average molecular weight: 29,400, number average molecular weight: 12,600, glass transition temperature: 160˚C) and 0.58 wt% of 4-isopropyl-4'-methyldiphenyliodonium tetrakis(pentafluorophenyl) borate as an electron-accepting compound, dissolved in ethyl benzoate, was prepared, and this composition was spin-coated to form a film on the above ITO substrate.

As spin coating conditions, the spin coating was carried out in two stages of a spinner rotational speed of 500 rpm for 2 seconds and a spinner rotational speed of 1,500 rpm for 30 seconds. As drying conditions, the heating was carried out for 3 hours by a clean oven of 230˚C, whereby a thin film having a thickness of 30 nm was formed.

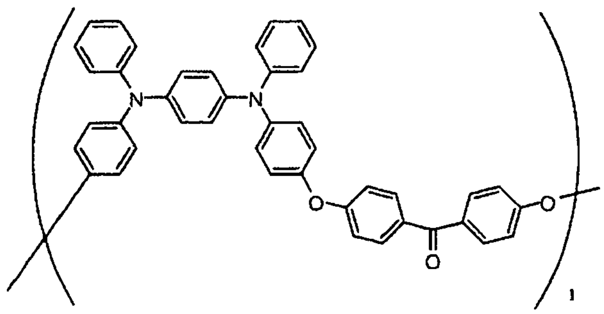

(1－2)

(Formation of hole transport layer)

Then, a hole transport layer was formed by a wet film-forming method as follows. As the material for the hole transport layer, a composition having 0.4 wt% of a polymer having a repeating structure of the following formula (HT-1) dissolved in dehydrated toluene, was prepared, and this composition was formed into a film on the above hole injection layer by a spin coating method in a nitrogen atmosphere.

As spin coating conditions, the spin coating was carried out in two stages of a spinner rotational speed of 500 rpm for 2 seconds and a spinner rotational speed of 1,500 rpm for 30 seconds. As drying conditions, the heating was carried out for one hour on a hotplate of 230˚C, whereby a thin film having a thickness of 20 nm was formed.

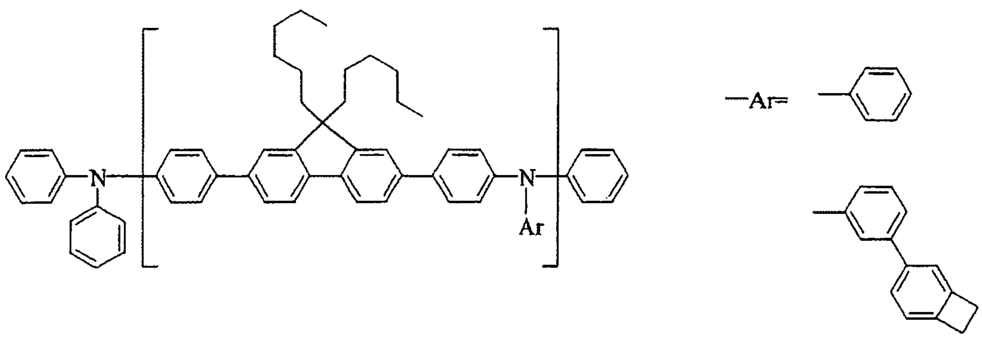

x 0.9409

x 0.0591

(HT－1)

(Film formation of light-emitting layer)

Then, a light-emitting layer was formed by a wet film-forming method as follows. As the material for the light-emitting layer, the following materials were used for film forming. As a blue light-emitting layer material, a composition was prepared by mixing the following BH-1 and BD-1 in a ratio of 100:10 (weight ratio) and dissolving 0.8 wt% of such a mixture in toluene, and this composition was spin-coated to form a film on the above hole transport layer in a nitrogen

atmosphere.

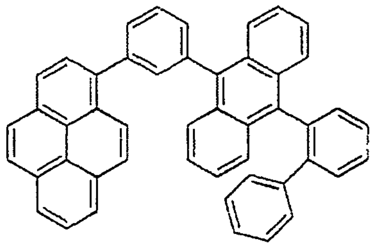

BH-1

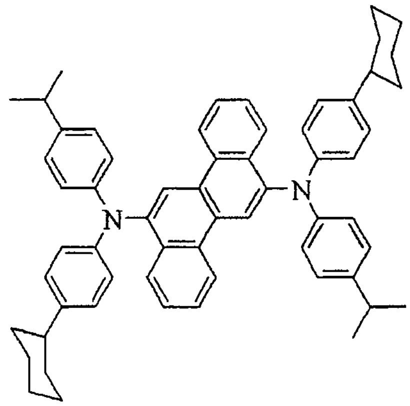

BD-1

As a green light-emitting layer material, a composition was prepared by mixing the following GH-1, GH-2 and GD-1 in a ratio of 50:50:5 (weight ratio), and dissolving 2.0 wt% of this mixture in xylene, and this composition was spin-coated to form a film on the hole transport layer in a nitrogen atmosphere.

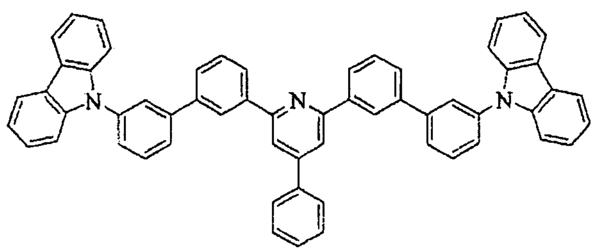

GH-1

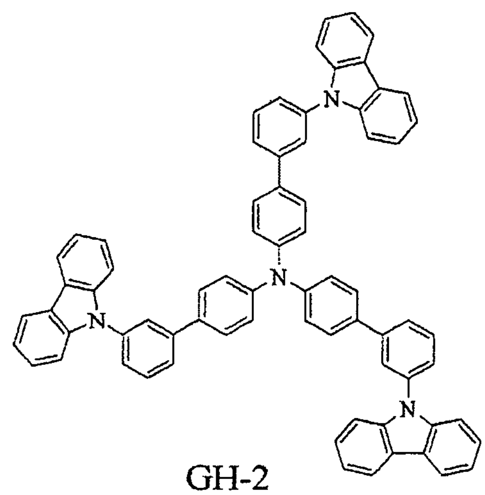

GH-2

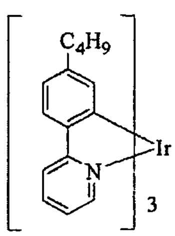

GD-1

As a red light-emitting layer material, a composition was prepared by mixing the following GH-1, GH-2, GD-1

and RD-1 in a ratio of 50:50:5:5 (weight ratio), and dissolving 2.0 wt% of this mixture in xylene, and this composition was spin-coated to form a film on the hole transport layer in a nitrogen atmosphere.

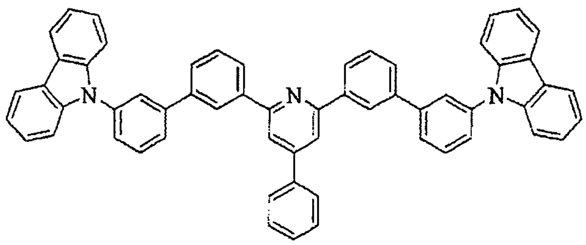

GH-1

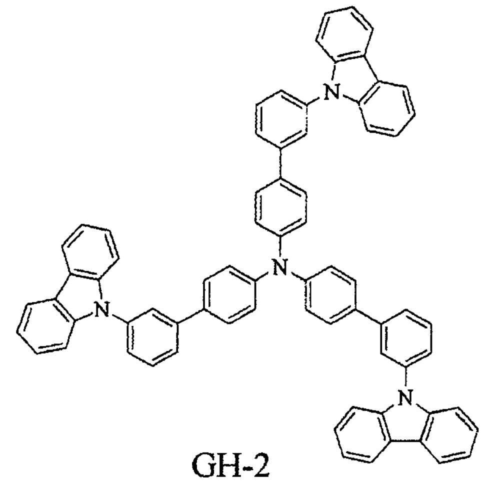

GH-2

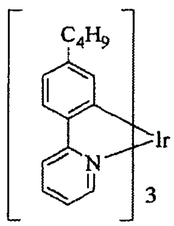

GD-1

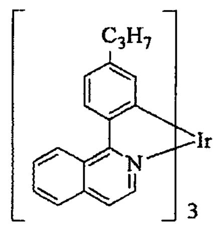

RD-1

As spin coating conditions, the spin coating was carried out in two stages of a spinner rotational speed of 500 rpm for 2 seconds and a spinner rotational speed of 1,500 rpm for 30 seconds. Then, the drying was carried out at 130˚C for one hour to form a light-emitting layer having a thickness of 50 nm.

(Film formation of hole relaxation layer)

On the obtained light-emitting layer, as a hole relaxation layer, a hole-relaxing material HA-1 was laminated by a vacuum vapor deposition method so that the film thickness would be 10 nm. The hole-relaxing material HA-1 had $\mu_E/\mu_H$ of 0.8.

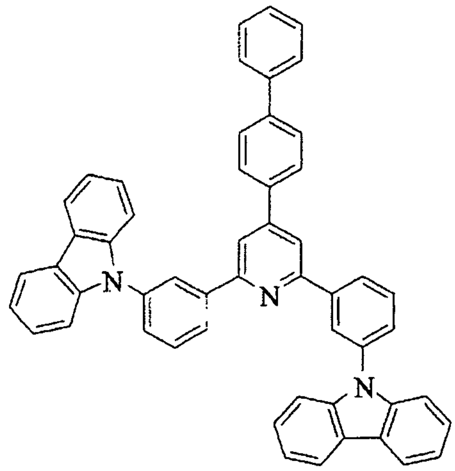

HA-1

(Film formation of electron transport layer)

On the obtained hole relaxation layer, as an electron transport layer 7, the following 8-hydroxyquinoline complex of aluminum ET-1 was laminated by a vacuum vapor deposition method so that the film thickness would be 30 nm.

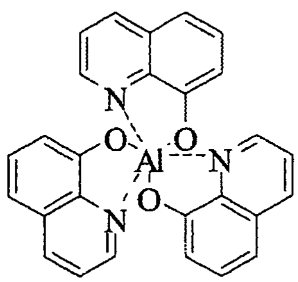

ET-1

(Film formation of electron injection layer and cathode, and sealing)

Here, the element having the vapor deposition carried out up to the electron transport layer 7, was taken out from the above vacuum vapor deposition apparatus to the atmospheric air, and as a mask for cathode vapor deposition, a shadow mask with stripes with a width of 2 mm perpendicular to the ITO stripes as the anode was adhered to the element, and then the element was set in a separate vacuum vapor deposition apparatus, and by the same vacuum vapor deposition method as used for the electron transport layer 7, lithium fluoride (LiF) was laminated in a film thickness of 0.5 nm as an electron injection layer 8, and then aluminum was laminated in a film thickness of 80.0 nm as a cathode 9.

Then, sealing treatment was carried out by the following method in order to prevent deterioration of the element by e.g. moisture in the atmospheric air during the storage.

In a nitrogen globe box connected to a vacuum vapor deposition apparatus, a photocurable resin was applied with a width of about 1 mm along the peripheral portion of a glass plate with a size of 23 mm × 23 mm, and at the center portion, a desiccating agent sheet was set. Thereon, the substrate having the cathode formation completed was bonded so that the vapor-deposited surface faced the desiccating agent sheet. Then, only the region coated with the photocurable resin was irradiated with ultraviolet light, and the resin was cured. Thus, an organic EL element having an emission area portion with a size of 2 mm × 2 mm, was obtained.

[REFERENCE EXAMPLE 2]

An organic EL element was prepared in the same manner as in Reference Example 1 except that in Reference Example 1, the hole-relaxing material HA-1 was changed to the following BAlq as a hole-blocking material.

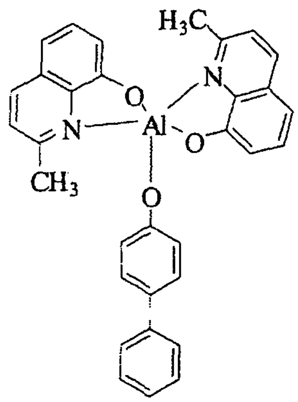

BAlq

[REFERENCE EXAMPLE 3]

An organic EL element was prepared in the same manner as in Reference Example 1 except that in Reference Example 1, the hole-relaxing material HA-1 was changed to the following HB-1 as a hole-blocking material.

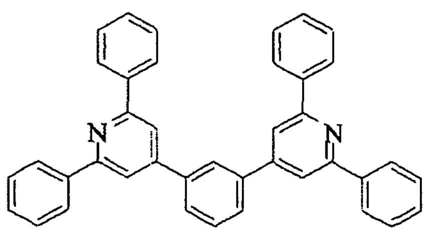

HB-1

[Results]

With respect to the organic EL elements obtained in Reference Examples 1, 2 and 3, respectively, the luminance half-time as measured by the following method is shown in the following Table 1.

[Measuring method]

<Luminance half-time>

The method for measuring the luminance half-time was carried out by observing by a photodiode a change in luminance when a voltage at which the luminance became 2,000 nit (only green element: 4,000 nit) when a DC constant current was applied to the prepared organic EL element during the test, whereby the time (luminance half-time) until the luminance value became a half of the value at the initiation of the test, i.e. 1,000 nit (only green element: 2,000 nit) was obtained. The current applying test was carried out in a room where the room temperature was controlled to be 23±1.5°C by air conditioning.

<Driving voltage>

In the method for measuring the driving voltage, a DC constant current was initially applied to the prepared organic EL element, whereby the voltage at which the luminance became 2,000 nit (only green element: 4,000 nit) was measured.

TABLE 1

| | Emission color | Hole-relaxing material (hole-blocking material) | Luminance half-time (hr) | Voltage rise (V) |
|---|---|---|---|---|
| Ref. Ex. 1 | Blue | HA-1 | 270 | 0.5 |
| | Green | HA-1 | 320 | 1 |
| | Red | HA-1 | 400 | 0.5 |
| Ref. Ex. 2 | Blue | BAlq | 200 | 1.5 |
| | Green | BAlq | 160 | 1.4 |
| | Red | BAlq | 290 | 1 |
| Ref. Ex. 3 | Blue | HB-1 | 80 | 1.8 |
| | Green | HB-1 | 250 | 1.5 |

As is evident from Table 1, in the case where a hole-blocking material was used for each color as in Reference Examples 2 and 3, the long life is not attained in every color. Further, in the case where the hole-blocking material BAlq was used in Reference Example 2, the voltage rise was high in green. Further, in the case where a hole-blocking material HB-1 was used in Reference Example 3, the life was short, and the voltage rise was large in blue.

Whereas, in the case where the hole-relaxing material like HA-1 was used as in Reference Example 1, the respective colors were stabilized, and the long life was obtained, and it was possible to suppress the voltage rise.

[REFERENCE EXAMPLE 4]

An organic EL element was prepared in the same manner as in Reference Example 1 except that in Reference Example 1, the hole-relaxing material HA-1 was changed to the following hole-relaxing material HA-2.

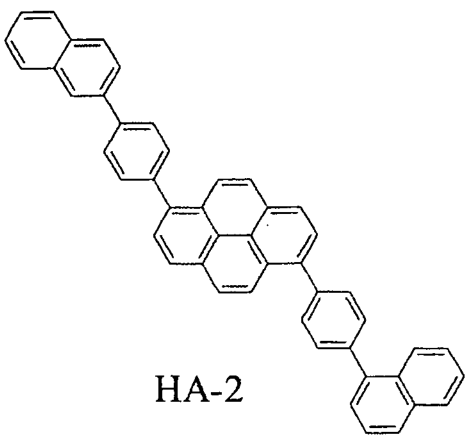

HA-2

[Results]

With respect to the organic EL elements obtained in Reference Examples 1, 4 and 3, respectively, the luminance half-time as measured by the following method is shown in Table 2.

TABLE 2

| | Emission color | Hole-relaxing material (hole-blocking material) | Luminance half-time (hr) | Voltage rise (V) |
|---|---|---|---|---|
| Ref. Ex. 1 | Blue | HA-1 | 270 | 0.5 |
| Ref. Ex. 4 | Blue | HA-2 | 200 | 0.7 |
| Ref. Ex. 3 | Blue | HB-1 | 80 | 1.8 |

As is evident from Table 2, it was found that the long life and low voltage can be attained by using the hole-relaxing material HA-1 or HA-2, as compared with the hole-blocking material HB-1 in Reference Example 3.

[EXAMPLE 1]

An organic EL element having the structure as shown in Fig. 1 was prepared by the following method.

(Preparation of ITO substrate)

An indium - tin oxide (ITO) transparent conductive film deposited in a thickness of 150 nm on a glass substrate 1 (a sputter-deposited product, sheet resistance: 15 Ω) was subjected to patterning in stripes with a width of 2 mm by means of a usual photolithography technique and hydrochloric acid etching to form an anode 2.

(Pre-treatment)

The substrate having the anode patterned as described above (ITO substrate) was subjected to cleaning in the order of ultrasonic cleaning by a surfactant, water washing by pure water and ultrasonic cleaning by isopropyl alcohol, then dried by compressed air and finally subjected to ultraviolet ray ozone cleaning for 1 minute.

(Film formation of hole injection layer)

Then, a hole injection layer was formed by a wet film-forming method as follows. As the material for the hole injection layer, a composition having 2 wt% of a polymer having a repeating structure of the following formula (H1-1) and 0.8 wt% of 4-isopropyl-4'-methyldiphenyliodonium tetrakis(pentafluorophenyl) borate as an oxidizing agent, dissolved in ethyl benzoate, was prepared, and this composition was spin-coated to form a film on the above ITO substrate.

As spin coating conditions, the spin coating was carried out in two stages of a spinner rotational speed of 500 rpm for 2 seconds and a spinner rotational speed of 1,500 rpm for 30 seconds. As drying conditions, the heating was carried out for one hour by a clean oven of 230˚C, whereby a thin film having a thickness of 30 nm was formed.

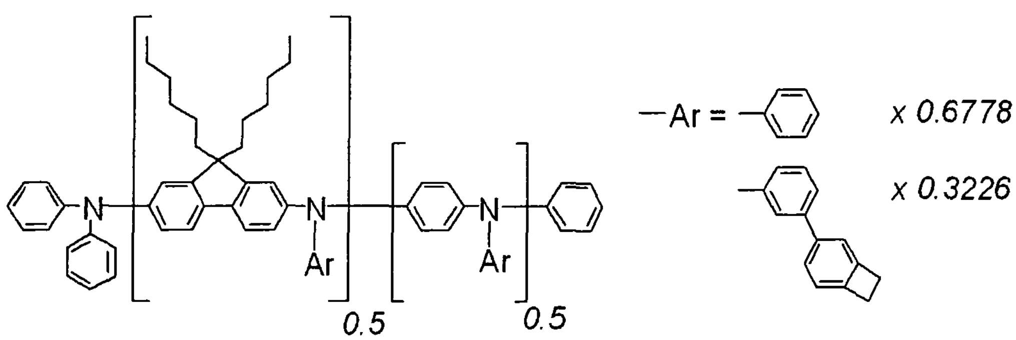

(H I − 1)

(Film formation of hole transport layer)

Then, a hole transport layer was formed by a wet film-forming method as follows. As the material for the hole

transport layer, a composition having 1.0 wt% of a polymer having a repeating structure of the following formula (HT-1) dissolved in cyclohexylbenzene, was prepared, and this composition was spin-coated to form a film on the above hole injection layer in a nitrogen atmosphere.

As spin coating conditions, the spin coating was carried out in two stages of a spinner rotational speed of 500 rpm for 2 seconds and a spinner rotational speed of 1,500 rpm for 30 seconds. As drying conditions, the heating was carried out for one hour on a hotplate of 230°C, whereby a thin film having a thickness of 15 nm was formed.

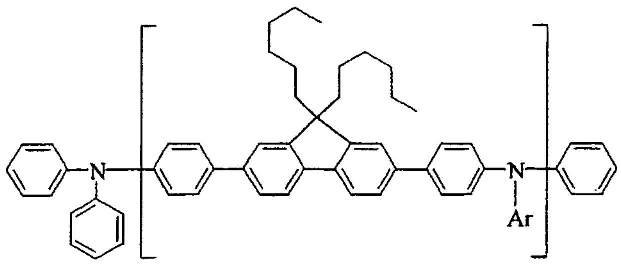

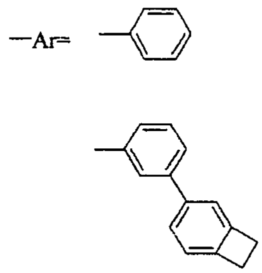

x 0.9409

x 0.0591

(HT-1)

(Film formation of light-emitting layer)

Then, a light-emitting layer was formed by a wet film-forming method as follows. As the material for the light-emitting layer, the following materials were used for film forming. As a red light-emitting layer material, a composition was prepared by mixing the following RH-1, GH-1, RD-1 and GD-1 in a ratio of 12:75:7:5 (weight ratio), and dissolving 5.0 wt% of this mixture in cyclohexylbenzene, and this composition was spin-coated to form a film on the above hole transport layer in a nitrogen atmosphere in two stages of a spinner rotational speed of 500 rpm for 2 seconds and a spinner rotational speed of 1,500 rpm for 30 seconds, whereby a red light-emitting layer having a thickness of 60 nm was formed.

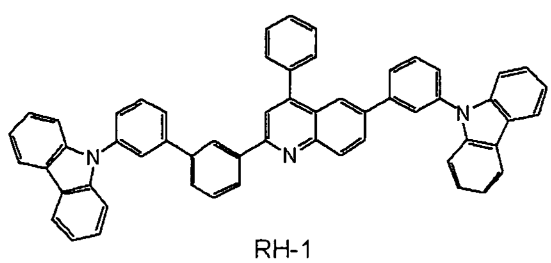

RH-1

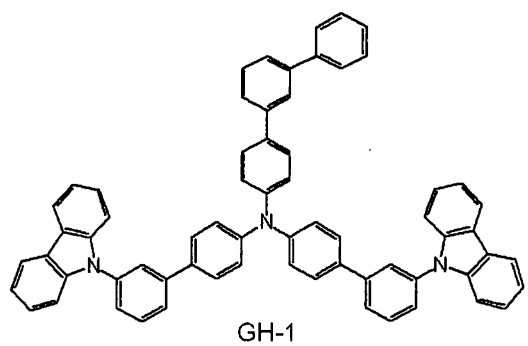

GH-1

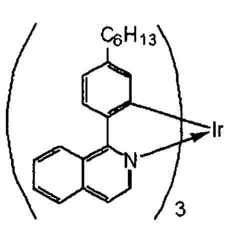

RD-1

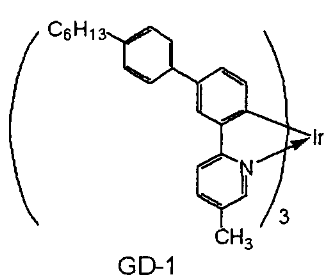

GD-1

As a green light-emitting layer material, a composition was prepared by mixing the following GH-2 and the

above-mentioned GH-1 and GD-1 in a ratio of 25:75:5 (weight ratio), and dissolving 5.0 wt% of this mixture in cyclohexylbenzene, and this composition was spin-coated to form a film on the above hole transport layer in a nitrogen atmosphere in two stages of a spinner rotational speed of 500 rpm for 2 seconds and a spinner rotational speed of 1,500 rpm for 30 seconds, whereby a green light-emitting layer having a thickness of 60 nm was formed.

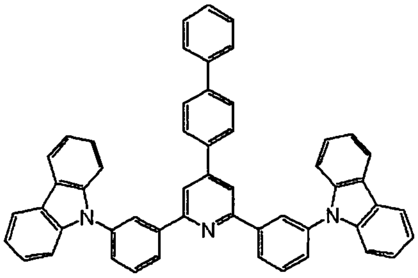

GH-2

As a blue light-emitting layer material, a composition was prepared by mixing the following BH-1 and BD-1 in a ratio of 100:10 (weight ratio), and dissolving 3.1 wt% of this mixture in cyclohexylbenzene, and this composition was spin-coated to form a film on the above hole transport layer in a nitrogen atmosphere in two stages of a spinner rotational speed of 500 rpm for 2 seconds and a spinner rotational speed of 1,500 rpm for 30 seconds, whereby a blue light-emitting layer having a thickness of 35 nm was formed.

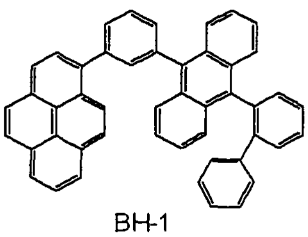

BH-1

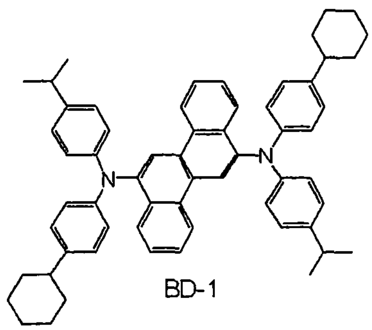

BD-1

(Film formation of hole relaxation layer)

On the obtained light-emitting layer, as a hole relaxation layer, the above GH-2 was laminated by a vacuum vapor deposition method so that the film thickness would be 10 nm. GH-2 had $\mu_E/\mu_H$ of 0.8 and a detectable amount of holes of $2.9\times10^{-10}$.

(Film formation of electron transport layer)

On the obtained hole relaxation layer, as an electron transport layer 7, the following 8-hydroxyquinoline complex of aluminum ET-1 was laminated by a vacuum vapor deposition method so that the film thickness would be 30 nm.

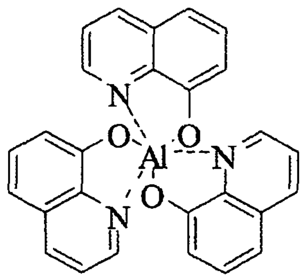

ET-1

(Film formation of electron injection layer and cathode, and sealing)

Here, the element having the vapor deposition carried out up to the electron transport layer 7, was once taken out from the above vacuum vapor deposition apparatus to the atmospheric air, and as a mask for cathode vapor deposition, a shadow mask with stripes with a width of 2 mm perpendicular to the ITO stripes as the anode was adhered to the element, and then the element was set in a separate vacuum vapor deposition apparatus, and by the same vacuum vapor deposition method as used for the electron transport layer 7, lithium fluoride (LiF) was laminated in a film thickness of 0.5 nm as an electron injection layer 8, and then aluminum was laminated in a film thickness of 80 nm as a cathode 9.

Then, sealing treatment was carried out by the following method in order to prevent deterioration of the element by e.g. moisture in the atmospheric air during the storage.

In a nitrogen globe box connected to a vacuum vapor deposition apparatus, a photocurable resin was applied with a width of about 1 mm along the peripheral portion of a glass plate with a size of 23 mm $\times$ 23 mm, and at the center portion, a desiccating agent sheet was set. Thereon, the substrate having the cathode formation completed was bonded so that the vapor-deposited surface faced the desiccating agent sheet. Then, only the region coated with the photocurable resin was irradiated with ultraviolet light, and the resin was cured. Thus, an organic EL element for each of red, green and blue colors having an emission area portion with a size of 2 mm $\times$ 2 mm, was obtained.

[EXAMPLE 2]

An organic EL element for each of red, green and blue colors was prepared in the same manner as in Example 1 except that in Example 1, GH-2 used as the hole-relaxing material was changed to RH-1. RH-1 had $\mu_E/\mu_H$ of 0.52 and a detectable amount of holes of $6.9\times10^{-10}$.

[COMPARATIVE EXAMPLE 1]

An organic EL element for each of red, green and blue colors was prepared in the same manner as in Example 1 except that the hole-relaxing material GH-2 used in Example 1 was changed to a charge-transporting material BH-1 not belonging to the hole-relaxing material of the present invention. BH-1 had $\mu_E/\mu_H$ of 17.2 and a detectable amount of holes of $4.5\times10^{-10}$.

[COMPARATIVE EXAMPLE 2]

An organic EL element for each of red, green and blue colors was prepared in the same manner as in Example 1 except that the hole-relaxing material GH-2 used in Example 1 was changed to the following hole-blocking material HB-1.

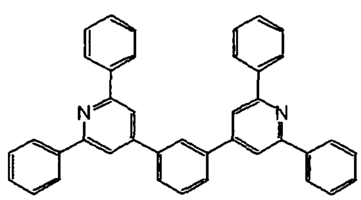

HB-1

[COMPARATIVE EXAMPLE 3]

An organic EL element for each of red, green and blue colors was prepared in the same manner as in Example 1 except that the hole-relaxing material GH-2 used in Example 1 was changed to the following hole-blocking material HB-2.

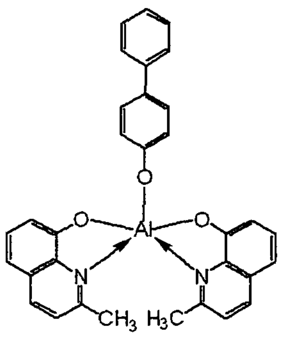

HB-2

[Measuring method]

<Luminance half-time>

The method for measuring the luminance half-time was carried out by observing by a photodiode a change in luminance when a voltage at which the luminance became 1,000 nit when a DC constant current was applied to the prepared organic EL element for each color during the test, whereby the time (luminance half-time) until the luminance value became a half of the value at the initiation of the test, i.e. 500 nit, was obtained. The current applying test was carried out in a room where the room temperature was controlled to be 23±1.5°C by air conditioning.

TABLE 3

| | Hole-relaxing material (hole-blocking material) | Color | Luminance half-time (hr) |
|---|---|---|---|
| Ex. 1 | GH-2 | Red | 1700 |
| | | Green | 20000 |
| | | Blue | 2200 |
| Ex. 2 | RH-1 | Red | 1800 |
| | | Green | 14000 |
| | | Blue | 2000 |
| Comp. Ex. 1 | BH-1 | Red | 4 |
| | | Green | 210 |
| | | Blue | 2400 |
| Comp. Ex. 2 | HB-1 | Red | 100 |
| | | Green | 170 |
| | | Blue | 900 |
| Comp. Ex. 3 | HB-2 | Red | 160 |
| | | Green | 170 |
| | | Blue | 1800 |

As shown in Table 3, it is evident that the organic EL element A of the present invention has a long driving life. Further, the organic EL element for each color has a long driving life, and accordingly, an organic light-emitting device containing the organic EL element of the present invention likewise has a long driving life.

[EXAMPLE 3]

An organic EL element for each of red, green and blue colors was prepared in the same manner as in Example 1 except that the conditions for forming the light-emitting layer in Example 1 were changed as follows.

(Red light-emitting layer)

A composition was prepared by mixing RH-1, GH-1, RD-1 and GD-1 in a ratio of 50:50:7:5 (weight ratio), and dissolving 5.0 wt% of this mixture in cyclohexylbenzene, and this composition was spin-coated to form a film on the hole transport layer in a nitrogen atmosphere in two stages of a spinner rotational speed of 500 rpm for 2 seconds and a spinner rotational speed of 1,500 rpm for 30 second to form a red light-emitting layer having a thickness of 60 nm.

(Green light-emitting layer)

A composition was prepared by mixing GH-2, and the above GH-1 and GD-1 in a ratio of 50:50:5 (weight ratio), and dissolving 5.0 wt% of this mixture in cyclohexylbenzene, and this composition was spin-coated to form a film on the hole transport layer in a nitrogen atmosphere in two stages of a spinner rotational speed of 500 rpm for 2 seconds and a spinner rotational speed of 1,500 rpm for 30 second to form a green light-emitting layer having a thickness of 60 nm.

(Blue light-emitting layer)

A composition was prepared by mixing BH-1 and GB-1 in a ratio of 100:10 (weight ratio), and dissolving 3.1 wt% of this mixture in cyclohexylbenzene, and this composition was spin-coated to form a film on the hole transport layer in a nitrogen atmosphere in two stages of a spinner rotational speed of 500 rpm for 2 seconds and a spinner rotational speed of 1,200 rpm for 30 second to form a blue light-emitting layer having a thickness of 45 nm.

TABLE 4

| | Hole-relaxing material (hole-blocking material) | Color | Luminance half-time (hr) |
|---|---|---|---|
| Ex. 3 | GH-2 | Red | 1800 |
| | | Green | 18000 |
| | | Blue | 4400 |

As shown in Table 4, the organic EL element A of the present invention has a long driving life. Further, with organic EL elements for respective colors, the respective driving service lives are long, and it is accordingly evident that an organic light-emitting device containing the organic EL element of the present invention likewise has a long driving life.

[EXAMPLE 4]

Preparation was carried out in the same manner as in Example 1 except for the following.

(Preparation of ITO substrate)

An anode was prepared in the same manner as in Example 3 except that in Example 1, the deposited film thickness of the indium · tin oxide (ITO) transparent conductive film on the glass substrate was changed from 150 nm to 70 nm.

(Light-emitting layer)

As the material for a light-emitting layer, a composition was prepared by mixing the above GH-1, GH-2, GD-1 and the following RD-2 in a ratio of 75:25:10:0.7 (weight ratio), and dissolving 5.0 wt% of this mixture in cyclohexylbenzene, and this composition was spin-coated to form a film on the hole transport layer in a nitrogen atmosphere.

As spin coating conditions, the spin coating was carried out in two stages of a spinner rotational speed of 500 rpm for 2 seconds and a spinner rotational speed of 1,500 rpm for 120 seconds. Then, drying was carried out at 130˚C for one hour, whereby a light-emitting layer having a thickness of 60 nm was formed.

Thus, it was possible to prepare a yellow organic EL element having a maximum emission at 522 nm and 611 nm.

[COMPARATIVE EXAMPLE 6]

An organic EL element was prepared in the same manner as in Example 4 except that in the film forming of the hole relaxation layer in Example 4, the hole-relaxing material GH-2 was changed to the hole-blocking material HB-2.

<Luminance half-time>

The method for measuring the luminance half-time was carried out by observing by a photodiode a change in luminance when a voltage at which the luminance became 2,000 nit when a DC constant current was applied to the prepared yellow organic EL element during the test, whereby the time (luminance half-time) until the luminance value became a half of the value at the initiation of the test, i.e. 1,000 nit, was obtained. The current applying test was carried out in a room where the room temperature was controlled to be 23±1.5˚C by air conditioning.

TABLE 5

| | Emission color | Hole-relaxing material (hole-blocking material) | Luminance half-time (hr) |
|---|---|---|---|
| Ex.4 | Yellow | GH-2 | 9800 |
| Comp. Ex. 6 | Yellow | HB-2 | 7800 |

As shown in Table 5, the organic EL element C of the present invention has a long driving life.

[EXAMPLE 5]

The operation up to formation of the hole transport layer was carried out in the same manner as in Example 1. Then, for a first light-emitting layer on the obtained hole-transport layer, a composition was prepared by mixing BH-1 and BD-1 in a ratio of 100:10 (weight ratio) and dissolving 2.4 wt% of this mixture in cyclohexylbenzene, and this composition was spin-coated to form a film on the hole transport layer in a nitrogen atmosphere in two stages of a spinner rotational speed of 500 rpm for 2 seconds and a spinner rotational speed of 1,200 rpm for 30 second. Then, drying was carried out at 130˚C for one hour, whereby a blue light-emitting layer having a thickness of 30 nm was formed.

On the obtained first light-emitting layer, as a second light-emitting layer, GH-2, GD-1 and RD-1 were co-vapor deposited by a vacuum vapor deposition method while adjusting the vapor deposition rate so that they would be in a ratio of 100:10:0.7 (weight ratio), whereby a yellow light-emitting layer having a thickness of 30 nm was formed.

On the obtained second light-emitting layer, in the same manner as in Example 1, GH-2 as the hole relaxation layer, ET-1 as the electron transport layer, the electron injection layer and the cathode were formed, followed by sealing treatment, to obtain a white organic EL element.

<Luminance half-time>

The method for measuring the luminance half-time was carried out by observing by a photodiode a change in luminance when a voltage at which the luminance became 2,000 nit when a DC constant current was applied to the prepared white organic EL element during the test, whereby the time (luminance half-time) until the luminance value became a half of the value at the initiation of the test, i.e. 1,000 nit, was obtained. The current applying test was carried out in a room where the room temperature was controlled to be 23±1.5˚C by air conditioning.

TABLE 6

| | Emission color | Hole-relaxing material (hole-blocking material) | Luminance half-time (hr) |
|---|---|---|---|
| Ex. 5 | White | G H-2 | 3100 |

As shown in Table 6, it is evident that the organic EL element D of the present invention has a long driving life.

INDUSTRIAL APPLICABILITY

The present invention is useful in various fields wherein organic EL elements are used, for example, in fields of flat panels/displays (e.g. for OA computers or wall-hung TV), light sources utilizing the characteristics as planar light-emitting devices (e.g. light sources for copy machines, backlight light sources for liquid crystal displays or meters),

display panels, sign lamps, etc.

The entire disclosure of Japanese Patent Application No. 2010-002972 filed on January 8, 2010 including specification, claims, drawings and summary is incorporated herein by reference in its entirety.

MEANINGS OF SYMBOLS

1 : Substrate
2: Anode
3: Hole injection layer
4: Hole transport layer
5: Light-emitting layer (5(a) and 5(b) represent separate light-emitting layers)
6: Hole-relaxation layer (Hole-blocking layer)
7: Electron transport layer
8: Electron injection layer
9: Cathode
10: Sample layer

## Claims

1. An organic EL element having a light-emitting layer between an anode and a cathode, wherein:

   the light-emitting layer contains a light-emitting material and a charge-transporting material,
   the element has a hole relaxation layer adjacent to the cathode side of the light-emitting layer,
   the hole relaxation layer contains a hole-relaxing material,
   the hole-relaxing material is an organic compound having a hole-transporting unit and an electron-transporting unit, and
   at least one type of the charge-transporting material and at least one type of the hole-relaxing material are the same organic compound.

2. The organic EL element according to Claim 1, wherein the charge-transporting material has a detectable amount of holes of from $2.5\times10^{-10}$ to $1\times10^{-8}$ at a field intensity of 160kV/cm.

3. The organic EL element according to Claim 1 or 2, wherein in the hole-relaxing material, the ratio ($\mu_E/\mu_H$) of the electron mobility $\mu_E$ to the hole mobility $\mu_H$ is from 100 to 0.1.

4. The organic EL element according to any one of Claims 1 to 3, wherein the hole-relaxing material is represented by the following formula (1):

$$(A)_m - (L)_l - (B)_n \qquad (1)$$

(in the formula (1), A each independently is a $C_{1-30}$ hole-transporting unit, which may have a substituent, B each independently is a $C_{1-30}$ electron-transporting unit, which may have a substituent, L is a $C_{1-10}$ alkylene group, a $C_{2-10}$ alkenylene group or a $C_{6-30}$ bivalent aromatic hydrocarbon group, which may have a substituent, each of n and m is an integer of from 1 to 4, and l is an integer of from 0 to 3, provided that in the formula (1), when l, m or n is 2 or more, a plurality of L, A or B may be the same or different, respectively.)

5. The organic EL element according to any one of Claims 1 to 3, wherein the hole-relaxing material is a compound having a structure represented by the following formula (2) or (3):

$B\left(L-A\right)_x$ (2)

$A\left(L-B\right)_y$ (3)

(in the formulae (2) and (3), A each independently is a $C_{1-30}$ hole-transporting unit, which may have a substituent, B each independently is a $C_{1-30}$ electron-transporting unit, which may have a substituent, L is a $C_{1-10}$ alkylene group, a $C_{2-10}$ alkenylene group or a $C_{6-30}$ bivalent aromatic hydrocarbon group, which may have a substituent, and each of x and y is an integer of from 1 to 4, provided that in the formula (2), when x is an integer of 2 or more, a plurality of L-A may be the same or different, and in the formula (3), when y is an integer of 2 or more, a plurality of L-B may be the same or different.)

**6.** The organic EL element according to any one of Claims 1 to 5, wherein the hole-relaxing material is an organic compound containing at least one ring selected from the following Group (a) as the hole-transporting unit and at least one ring selected from the following Group (b) as the electron-transporting unit:

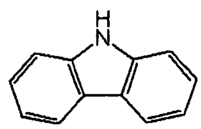 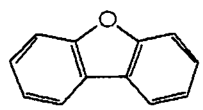 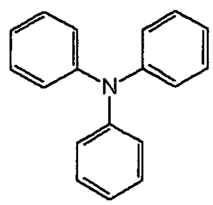 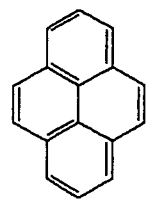

Group (a)

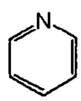 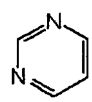 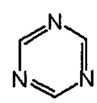

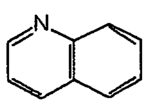 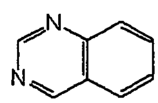 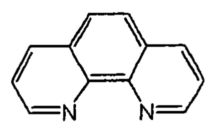

Group (b)

(provided that each of the rings contained in Group (b) has all of the o- and p-positions to each nitrogen atom substituted by aromatic rings.)

**7.** The organic EL element according to any one of Claims 1 to 6, which further has a hole injection layer, a hole transport layer and an electron transport layer, and wherein from the anode side, the hole injection layer, the hole transport layer, the light-emitting layer, the hole relaxation layer and the electron-transport layer are laminated in this order.

**8.** The organic EL element according to Claim 7, wherein the hole injection layer, the hole transport layer and the light-emitting layer are layers formed by a wet film-forming method, and the hole relaxation layer and the electron transport layer are layers formed by a vapor deposition method.

**9.** An organic light-emitting device having red, green and blue organic EL elements, wherein at least one of the red, green and blue organic EL elements is the organic EL element as defined in any one of Claims 1 to 8.

**10.** The organic light-emitting device according to Claim 9, wherein at least two organic EL elements different in color are the organic EL elements as defined in any one of Claims 1 to 8, and the hole-relaxing materials contained in the hole relaxation layers in said at least two organic EL elements different in color are the same organic compound.

**11.** The organic EL element according to any one of Claims 1 to 8, wherein the light-emitting layer contains at least two light-emitting materials.

**12.** The organic EL element according to any one of Claims 1 to 8, wherein the light-emitting layer comprises at least two layers containing different light-emitting materials from one another.

**13.** An organic EL display device containing the organic EL element as defined in Claim 11 or 12.

**14.** An organic EL illumination containing the organic EL element as defined in Claim 11 or 12.

Fig. 1

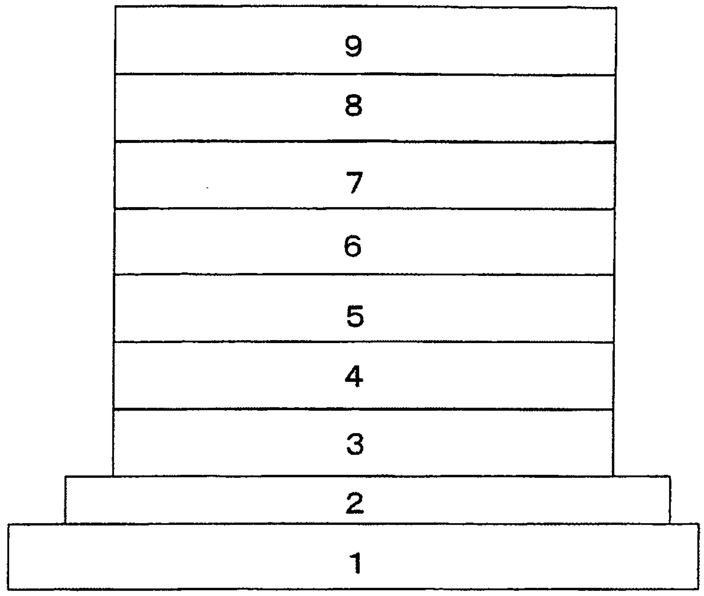


Fig. 2

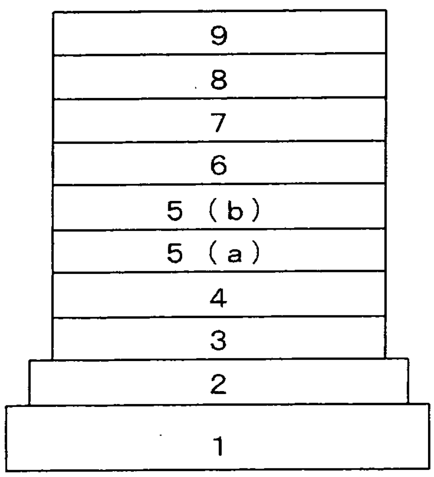


Fig. 3

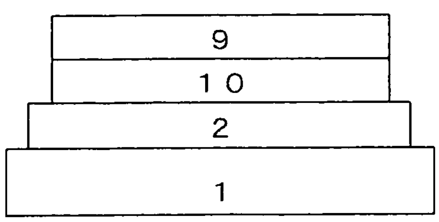

## INTERNATIONAL SEARCH REPORT

International application No.
PCT/JP2010/051446

A. CLASSIFICATION OF SUBJECT MATTER
*H01L51/50*(2006.01)i, *C09K11/06*(2006.01)i, *H05B33/12*(2006.01)i

According to International Patent Classification (IPC) or to both national classification and IPC

B. FIELDS SEARCHED

Minimum documentation searched (classification system followed by classification symbols)
H01L51/50, C09K11/06, H05B33/12

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2009-141339 A (Mitsubishi Chemical Corp.), 25 June 2009 (25.06.2009), paragraphs [0050], [0051], [0114] to [0165], [0194] to [0221] (Family: none) | 1-14 |
| Y | JP 2006-156445 A (Konica Minolta Holdings, Inc.), 15 June 2006 (15.06.2006), paragraphs [0100], [0122] to [0126], [0147] to [0153], [0183] to [0186] (Family: none) | 1-14 |

☒ Further documents are listed in the continuation of Box C. ☐ See patent family annex.

* Special categories of cited documents:
- "A" document defining the general state of the art which is not considered to be of particular relevance
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| 24 March, 2010 (24.03.10) | 06 April, 2010 (06.04.10) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2010/051446

C (Continuation). DOCUMENTS CONSIDERED TO BE RELEVANT

| Category* | Citation of document, with indication, where appropriate, of the relevant passages | Relevant to claim No. |
|---|---|---|
| Y | WO 2005/022962 A1 (Mitsubishi Chemical Corp.), 10 March 2005 (10.03.2005), pages 173 to 175 & JP 2005-268199 A & US 2006/0186796 A1 & EP 1672961 A1 & KR 10-2006-0096980 A & CN 1833470 A & CN 101638380 A | 1-14 |
| Y | JP 2007-12510 A (Konica Minolta Holdings, Inc.), 18 January 2007 (18.01.2007), claims 1 to 10 (Family: none) | 1-14 |
| A | WO 2009/008357 A1 (Idemitsu Kosan Co., Ltd.), 15 January 2009 (15.01.2009), paragraphs [0249] to [0278] (Family: none) | 1-14 |
| A | WO 2008/072539 A1 (Idemitsu Kosan Co., Ltd.), 19 June 2008 (19.06.2008), paragraphs [0035], [0056] to [0058] & JP 2008-147426 A | 1-14 |
| A | JP 2008-147424 A (Idemitsu Kosan Co., Ltd.), 26 June 2008 (26.06.2008), paragraphs [0026], [0035] to [0037] (Family: none) | 1-14 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2001284056 A
- JP 2006156848 A
- JP 2005158668 A
- JP 2003077660 A
- JP 2005044790 A
- WO 2005076669 A
- JP 5234681 A
- WO 2005089024 A
- JP 11251067 A
- JP 2003031365 A
- JP 7053953 A
- JP 59194393 A
- US 5645948 A
- JP 6207169 A
- JP 5331459 A
- JP 10270171 A
- JP 2002100478 A
- JP 2002100482 A
- JP 2010002972 A

### Non-patent literature cited in the description

- *Appl. Phys. Lett.,* 1999, vol. 74, 442
- *Japanese J. Appl. Phys.,* 1999, vol. 38, L1502
- *Proc. SPIE,* 2001, vol. 4105, 175
- *Appl. Phys. Lett.,* 2002, vol. 81, 162
- *Journal of Luminescence,* 1997, vol. 72-74, 985
- *Chemical Communications,* 1996, 2175
- *Synthetic Metals,* 1997, vol. 91, 209
- *Appl. Phys. Lett.,* 1992, vol. 60, 2711
- *J. Lumin,* 1997, vol. 72-74, 985
- *Chem. Commun.,* 1996, 2175
- *Synth. Metals,* 1997, vol. 91, 209
- *Polym. Adv. Tech.,* 1996, vol. 7, 33
- **Shizuo Tokito ; Chihaya Adachi ; Hideyuki Murata.** ORGANIC EL DISPLAY. Ohmsha, Ltd, 20 August 2004